(19) **Europäisches Patentamt / European Patent Office / Office européen des brevets**

(11) **EP 4 439 102 B1**

(12) **EUROPEAN PATENT SPECIFICATION**

(45) Date of publication and mention
of the grant of the patent:
**29.07.2026 Bulletin 2026/31**

(21) Application number: **22898284.9**

(22) Date of filing: **20.10.2022**

(51) International Patent Classification (IPC):
**G01R 31/392** (2019.01)   **G01R 31/378** (2019.01)
**G01R 31/389** (2019.01)   **H01M 10/42** (2006.01)
**H01M 10/48** (2006.01)   **H02J 7/00** (2026.01)
**G01R 31/36** (2020.01)   **G01R 31/367** (2019.01)
**G01R 31/3842** (2019.01)

(52) Cooperative Patent Classification (CPC):
**H01M 10/42; G01R 31/36; G01R 31/367;
G01R 31/378; G01R 31/3842; G01R 31/389;
G01R 31/392; H01M 10/48; Y02E 60/10**

(86) International application number:
**PCT/JP2022/039154**

(87) International publication number:
**WO 2023/095500 (01.06.2023 Gazette 2023/22)**

(54) **SECONDARY CELL STATE DIAGNOSIS METHOD, AND STATE DIAGNOSIS DEVICE**

VERFAHREN ZUR DIAGNOSE DES SEKUNDÄRZELLENZUSTANDS UND
ZUSTANDSDIAGNOSEVORRICHTUNG

PROCÉDÉ DE DIAGNOSTIC D'ÉTATS DE PILE RECHARGEABLE ET DISPOSITIF DE
DIAGNOSTIC D'ÉTATS

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **25.11.2021 JP 2021191298**

(43) Date of publication of application:
**02.10.2024 Bulletin 2024/40**

(73) Proprietor: **Hitachi, Ltd.**
**Tokyo 100-8280 (JP)**

(72) Inventors:
• **HONKURA, Kohei**
**Tokyo 100-8280 (JP)**
• **NISHIJIMA, Shun**
**Tokyo 100-8280 (JP)**

(74) Representative: **MERH-IP Matias Erny Reichl
Hoffmann
Patentanwälte PartG mbB
Paul-Heyse-Straße 29
80336 München (DE)**

(56) References cited:
CN-A- 105 242 212   JP-A- 2014 149 280
JP-A- 2014 160 592   JP-A- 2015 230 817
JP-B1- 6 918 433   KR-B1- 101 610 906
US-A1- 2020 217 901   US-A1- 2021 167 607
US-A1- 2021 270 907

• HONKURA, KOHEI; ODA, MASANARI; ITO,
SHOTA; SUGIMASA, MASATOSHI; KAWAJI, JUN:
"Prediction technique of capacity fade and
impedance rise of LIB based on the discharge
curve analysis", 60TH BATTERY SYMPOSIUM IN
JAPAN; NOVEMBER 13 - 15, 2019, vol. 60, 13
November 2019 (2019-11-13) - 15 November 2019
(2019-11-15), pages 550, XP009546596

**Description**

Technical Field

The present invention relates to a secondary cell state diagnosis method, and a state diagnosis device.

Background Art

In recent years, secondary cells such as lithium ion batteries have been used as driving power sources mounted in vehicles and as power sources for power storage in smart houses or the like, and advances have been made in equipment energy efficiency. It is known that the battery characteristics of lithium ion batteries or the like deteriorate during repeated charge and discharge or during storage in a high-temperature environment. Because driving power sources and power sources for power storage are used for long periods, deterioration must be minimized and safety secured for long periods of time.

The active material used for a lithium ion battery may be selected not only from the viewpoint of performance such as capacitance and voltage, but also from the standpoint of suppressing deterioration and improving safety. For example, $Li(Ni, Mn, CO)O_2$, $LiFePO_4$, or the like is used as the positive electrode active material. As the negative electrode active material, graphite, $Li_4Ti_5O_{12}$, or the like is used.

It is known that deterioration of a secondary cell such as a lithium ion battery progresses quickly in a high potential region having a high state of charge or a low potential region having a low state of charge. Deterioration of the secondary cell occurs due to a change in characteristics of the constituent elements of the positive electrode, the negative electrode, the electrolytic solution, and so forth. As the deterioration progresses, a charge/discharge curve, an operating voltage range, and the like change, which affects safety. In order to suppress the deterioration of the secondary cell, it is necessary to accurately detect the deterioration of the positive electrode and the negative electrode and select an optimum control method and usage conditions according to the detected state.

PTL 1 discloses a method for detecting internal information of a secondary cell. Using this method, the state of the positive electrode and the state of the negative electrode are quantitatively evaluated in a non-destructive manner by using the charge/discharge curve of the positive electrode alone or the negative electrode alone. The charge/discharge curve of the negative electrode alone and the charge/discharge curve of the positive electrode alone are superimposed and calculated to reproduce the charge/discharge curve of the secondary cell.

In addition, PTL 2 discloses an internal state estimation apparatus including a capacity estimator, a charge amount estimator, and a SOC estimator. The capacity estimator calculates an estimate capacity of the electrode based on an estimate capacity of the electrode at the first time point, a coefficient that is dependent at least on a SOC of the electrode at the first time point, and the time difference.

Further, PTL 3 discloses an insulation resistance estimation device that calculates a battery voltage from a voltage applied to a measurement resistor connected to a capacitor and measures an insulation resistance based on the calculated battery voltage, thereby capturing the peak voltage generated when the switch for insulation resistance is closed.

Moreover, PTL 4 discloses a degradation-determination system including a volume change detecting unit configured to detect a volume change of a lithium-ion battery, a capacity change detecting unit configured to detect a capacity change of the lithium-ion battery, and a charge control unit configured to control charge of the lithium-ion battery.

In addition, in PTL 5, a battery deterioration prediction system, specifically a polarization calculation unit, calculates negative and positive electrode polarizations from negative and positive electrode resistances, and an electrical current value flowing through the secondary battery. A CCP calculation unit further calculates a negative electrode closed-circuit potential on the secondary battery negative electrode open circuit potential and the negative electrode polarization calculated by the polarization calculation unit, and calculates a positive electrode closed-circuit potential based on the secondary battery positive electrode open circuit potential and the positive electrode polarization calculated by the polarization calculation unit.

Moreover, PTL 6 discloses a secondary battery system in which operation of a secondary battery is controlled by means of measuring the potentials of a negative and positive electrode of the secondary battery, and calculating SOC from the measured potentials.

Furthermore, PTL 7 discloses a method for controlling a secondary battery device by providing a battery pack including at least one nonaqueous electrolyte secondary battery using lithium titanate as a negative electrode active material, while further a monitoring circuit for detecting a battery voltage and a current detection unit for detecting a current of a main circuit are introduced, by which, in combination with an SOC calculation unit, an impedance of the battery to the AC voltage/current outputted from an AC oscillation source is calculated.

In addition, PTL 8 discloses a technique for evaluating battery deterioration by estimating internal resistance from temperature, current, and voltage measurements together with stored electrode characteristics. The method then derives reaction, ohmic, and diffusion resistance components and applies temperature correction to produce a compensated internal-resistance value.

Further, PTL 9 discloses a deterioration-diagnosis device controlling battery charging and discharging, that is configured to measure voltage, current, capacity, and temperature, and integrate capacity-voltage data from multiple cycles to generate a refined capacity-voltage curve for evaluating battery aging.

Moreover, PTL 10 discloses a method for extracting health-state parameters of lithium iron phosphate batteries for gradient utilization by charging the battery at a low current, modeling its charging behavior, and computing available capacity through ampere-hour integration.

Lastly, the content of NPTL 1 discloses a technique for predicting lithium-ion battery capacity fade in which cell discharge curves are decomposed into positive- and negative-electrode contributions, deterioration indicators are extracted over time, and time-evolution functions of those indicators are used to reconstruct future discharge curves.

Citation List

Patent Literature

PTL 1: JP 2009 080093 A
PTL 2: US 2020/217901 A1
PTL 3: KR 101 610 906 B1
PTL 4: US 2021/167607 A1
PTL 5: US 2021/270907 A1
PTL 6: JP 2015 230817 A
PTL 7: JP 2014 160592 A
PTL 8: JP 2014 149280 A
PTL 9: JP 6 918433 B1
PTL 10: CN 105 242 212 A

Non-Patent Literature

NPTL 1: Honkura, Kohei; Oda, Masanari; Ito, Shota; Sugimasa, Masatoshi; Kawaji, Jun: "Prediction technique of capacity fade and impedance rise of LIB based on the discharge curve analysis", 60th Battery Symposium in Japan; November 13 - 15, 2019, vol. 60, 13 November 2019 (2019-11-13), - 15 November 2019 (2019-11-15), page 550, XP009546596

Summary of Invention

Technical Problem

In PTL 1, the relationship between the discharge amount and the potential change rate is used for both the positive electrode and the negative electrode. However, there is a problem that such a method cannot be used in a case where an active material is used which has a potential that hardly changes in response to a change in the state of charge. For example, the electrode potential of lithium iron phosphate ($LiFePO_4$) or the like, which is used as a positive electrode active material, hardly changes even if the discharge is continued within a general operating voltage range, and thus it is not possible to use the relationship between the discharge amount and the potential change rate in the diagnosis of the deterioration state.

In the technique of PTL 1, when an active material having a potential which is less likely to change in response to a change in a state of charge is used for one electrode of the positive electrode and the negative electrode, only a deterioration state of the other electrode can be diagnosed, and thus there is a problem in that deterioration of the electrode which cannot be diagnosed potentially progresses. When the deterioration potentially progresses, the secondary cell rapidly deteriorates at the stage where the deterioration becomes apparent after a certain time elapses, and thus the safety of the secondary cell is a concern.

Therefore, an object of the present invention is to provide a secondary cell state diagnosis method and a secondary cell state diagnosis device that, even in a case where an active material having a potential that hardly changes in response to a change in a state of charge is used for the electrodes of a secondary cell, enable diagnosis of the deterioration of a secondary cell or each electrode.

Solution to Problem

In order to solve the above problems, the secondary cell state diagnosis method and the state diagnosis device according to the herein presented claims are suggested. Dependent claims describe favorable embodiments of the present invention.

Advantageous Effects of Invention

According to the present invention, it is possible to provide a secondary cell state diagnosis method and a secondary cell state diagnosis device that, even in a case where an active material having a potential that hardly changes in response to a change in a state of charge is used for the electrodes of a secondary cell, enable diagnosis of the deterioration of a secondary cell or each electrode.

Brief Description of Drawings

[FIG. 1] FIG. 1 is a diagram illustrating a configuration of a state diagnosis device for a secondary cell according to the present embodiment.
[FIG. 2] FIG. 2 is a flowchart showing processing of a secondary cell state diagnosis method.
[FIG. 3] FIG. 3 is a diagram showing an example of the relationship between a state of charge and an open-circuit potential of an electrode.
[FIG. 4] FIG. 4 is a diagram showing an example of the relationship between the state of charge and the open-circuit potential of an electrode.
[FIG. 5] FIG. 5 is a diagram showing an example of an evaluation result of the relationship between the state of charge and the open-circuit potential of the secondary cell at the stage where evaluation of one electrode is complete.
[FIG. 6] FIG. 6 is a diagram showing an example of the relationship between the state of charge and internal resistance of an electrode.
[FIG. 7] FIG. 7 is a diagram showing an example of the relationship between the state of charge and internal resistance of an electrode.
[FIG. 8] FIG. 8 is a diagram showing an example of an evaluation result of the relationship between the state of charge and internal resistance of the secondary cell at the stage where a deterioration state of the other electrode is assumed.
[FIG. 9] FIG. 9 is a diagram showing an example of an evaluation result of the relationship between the state of charge and the internal resistance of the secondary cell at the stage where the evaluation of the other electrode is complete.
[FIG. 10] FIG. 10 is a diagram showing an example of the relationship between the state of charge and the open-circuit potential of the secondary cell.

Description of Embodiments

Hereinafter, a secondary cell state diagnosis method and a secondary cell state diagnosis device according to an embodiment of the present invention will be described. Note that the same reference numerals are assigned to the same configurations in the following drawings, and thus redundant descriptions will be omitted.
A secondary cell state diagnosis method according to the present embodiment relates to a method for diagnosing a deterioration state of a secondary cell. Using this state diagnosis method, a secondary cell having an unknown deterioration state is to be diagnosed, and the secondary cell is diagnosed in a non-destructive manner. Using this state diagnosis method, the deterioration state of the secondary cell and the deterioration state of each of the positive electrode and the negative electrode electrodes included in the secondary cell can be individually diagnosed by measuring the open-circuit voltage and the internal resistance of the secondary cell to be diagnosed.
Using the secondary cell state diagnosis method according to the present embodiment, it is preferable to take, as a diagnosis target, a secondary cell in which an active material having a potential which hardly changes in response to a change in a state of charge is used for one of the positive electrode and the negative electrode. In a case where one electrode of the positive electrode and the negative electrode is an electrode in which the open-circuit potential is constant except close to a fully charged state and close to a completely discharged state, and the other electrode is an electrode in which the open-circuit potential is not constant from close to the fully charged state to close to the completely discharged state, diagnosis can be performed highly accurately.
In the present specification, the fact that the open-circuit potential of the electrode is constant except close to the fully charged state and close to the completely discharged state means that the range of change in the open-circuit potential of the electrode in response to a change in the state of charge is 30 mV or less within the used voltage range of the secondary cell except close to a fully charged state or close to a completely discharged state. When a state of charge (SOC) [%] is used, the region close to the fully charged state is defined as a region where the SOC is on the order of 80% or more, and the region close to the completely discharged state is defined as a region where the SOC is on the order of 20% or less.

Examples of an electrode in which the open-circuit potential is constant except close to the fully charged state and close to the completely discharged state include electrodes which use lithium iron phosphate ($LiFePO_4$), lithium titanate ($Li_4Ti_5O_{12}$, $Li_2TiO_3$), and the like. Examples of electrodes in which the open-circuit potential is not constant include electrodes using other materials such as graphite, lithium cobalt oxide ($LiCoO_2$), or the like.

Using the secondary cell state diagnosis method according to the present embodiment, the open-circuit voltage and the internal resistance of the secondary cell to be diagnosed are measured at the time of performing diagnosis. The relationship between the state of charge and the open-circuit voltage of the secondary cell and the relationship between the state of charge and the internal resistance of the secondary cell are calculated on the basis of the measurement result of the open-circuit voltage and the measurement result of the internal resistance. Data representing these relationships is stored in a storage unit of a device that diagnoses the state of the secondary cell.

Diagnostic processing is performed for each of the positive electrode and the negative electrode electrodes. First, for one electrode of the positive electrode and the negative electrode, the deterioration state of the electrode is evaluated on the basis of the relationship between the state of charge and the open-circuit potential of the electrode stored in the storage unit and the measurement-based relationship between the state of charge and the open-circuit voltage of the secondary cell. Thereafter, for the other electrode, the electrode deterioration state is evaluated on the basis of the relationship between the state of charge and the internal resistance stored in the storage unit and the relationship between the state of charge and the internal resistance of the secondary cell on the basis of the measurement.

In the evaluation of the deterioration state for each electrode, the relationship between the state of charge and the open-circuit potential of the electrode stored in the storage unit and the relationship between the state of charge and the internal resistance of the electrode stored in the storage unit are corrected by assuming the deterioration state of each electrode of the secondary cell to be diagnosed. On the basis of the corrected relationship between the state of charge and the open-circuit potential of the electrode and the corrected relationship between the state of charge and the internal resistance of the electrode, the relationship between the state of charge and the open-circuit voltage of the secondary cell and the relationship between the state of charge and the internal resistance of the secondary cell are calculated. As the relationship between the state of charge and the open-circuit potential of the electrode, the relationship between the state of charge and the open-circuit potential of the electrode having a known deterioration state can be used. The electrode having a known deterioration state is, for example, an electrode in an initial state.

Subsequently, the calculated relationship between the state of charge and the open-circuit voltage of the secondary cell and the calculated relationship between the state of charge and the internal resistance of the secondary cell are compared with the measurement-based relationship between the state of charge and the open-circuit voltage of the secondary cell and the measurement-based relationship between the state of charge and the internal resistance of the secondary cell. By fitting the computation result to the measurement result by using the deterioration states of each electrode of the secondary cell as variables, the correction performed by assuming the deterioration states of each electrode is optimized toward the true values. Therefore, it is possible to diagnose the deterioration state of each electrode and the deterioration state of the secondary cell from the content of the correction.

In the present specification, the state of charge means an electrochemical state determined by the ratio of the dischargeable amount of electricity to the amount of electricity that can be discharged from the fully charged state. The state of charge can be expressed by mutually convertible appropriate state quantities, such as the depth of charge SOC [%], the discharge amount [Ah] from a fully charged state, the charge amount [Ah] from a completely discharged state, and the composition ratio of the electrical charge carrier elements contained in the active material.

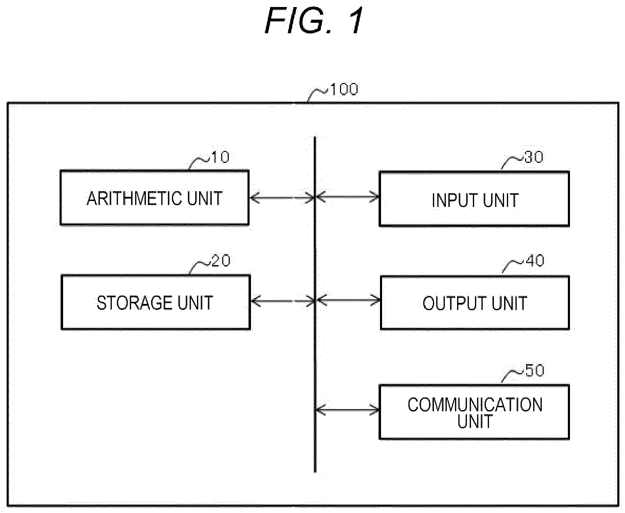

FIG. 1 is a diagram illustrating a configuration of a secondary cell state diagnosis device according to the present embodiment.

As illustrated in FIG. 1, the secondary cell state diagnosis device 100 according to the present embodiment includes an arithmetic unit 10, a storage unit 20, an input unit 30, an output unit 40, and a communication unit 50. The state diagnosis device 100 can be constituted by hardware such as a computer.

The state diagnosis device 100 reads measurement data obtained by actual measurement or reference data prepared in advance for each type of active material to execute, according to a predetermined program, a secondary cell state diagnosis method for diagnosing a deterioration state of the secondary cell. The arithmetic unit 10, the storage unit 20, the input unit 30, the output unit 40, and the communication unit 50 of the state diagnosis device 100 are connected to a bus.

The arithmetic unit 10 reads various data and programs, executes programs, calculates states, and the like. The arithmetic unit 10 includes, for example, a computation device such as a central processing unit (CPU).

The storage unit 20 stores various data and programs. The storage unit 20 includes, for example, a storage device such as a random access memory (RAM) or a read only memory (ROM). Various data and programs may be stored in a writable and readable hard disk, a flash memory, a magnetic disk, an optical disk, or the like.

The input unit 30 is a device that receives an input made by an operator. The input unit 30 includes, for example, a keyboard, a mouse, a touch panel, and the like. The input unit 30 can be connected via an input interface (not illustrated).

The output unit 40 is a device that outputs operation information of the state diagnosis device 100, the content of various data, a diagnostic condition, a diagnosis result, and the like. The output unit 40 includes, for example, a liquid crystal display, an organic EL display, a positive electrode ray tube, or the like. The output unit 40 can be connected via an output interface (not illustrated).

The communication unit 50 transmits and receives various data and control signals to and from an external measurement device or the like. The communication unit 50 can be connected via a communication interface, an input/output interface, and the like (not illustrated). As a measurement device, a battery tester based on the four-terminal method or the like can be connected.

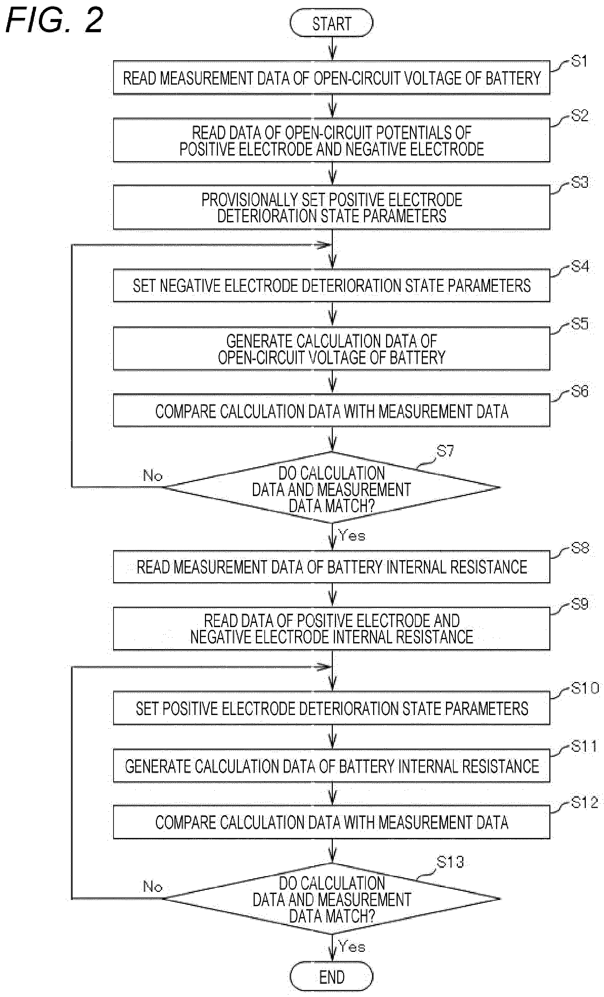

FIG. 2 is a flowchart showing processing of a secondary cell state diagnosis method.

As shown in FIG. 2, using the secondary cell state diagnosis method according to the present embodiment, the deterioration state of the secondary cell is evaluated by sequentially evaluating the deterioration state of each of the positive electrode and the negative electrode electrodes on the basis of the relationship between the state of charge and the open-circuit voltage and the relationship between the state of charge and the internal resistance.

FIG. 2 illustrates a case where the positive electrode is an electrode in which the open-circuit potential is constant except close to the fully charged state and close to the completely discharged state, and the negative electrode is an electrode in which the open-circuit potential is not constant from close to the fully charged state to close to the completely discharged state. In this example, the deterioration state of each electrode is evaluated in the order of the negative electrode and then the positive electrode.

The state diagnosis device 100 receives, as an input, measurement data indicating the relationship between the state of charge and the open-circuit voltage of the secondary cell to be diagnosed, and measurement data indicating the relationship between the state of charge and the internal resistance of the secondary cell to be diagnosed, and performs processing to evaluate the deterioration state for each electrode. The deterioration state of each electrode of the secondary cell to be diagnosed for which the deterioration state is unknown can be evaluated by taking, as an input, measurement data that can be acquired in a manner which is nondestructive for the secondary cell.

When the deterioration state is to be diagnosed, measurement data indicating the relationship between the state of charge and the open-circuit voltage of the secondary cell to be diagnosed, and measurement data indicating the relationship between the state of charge and the internal resistance of the secondary cell to be diagnosed are obtained on the basis of actual measurement and then stored in the storage unit 20. These pieces of measurement data may be represented by a relational expression or a data table.

These pieces of measurement data can be obtained for the secondary cell to be diagnosed by repeating measurement of the open-circuit voltage in an arbitrary state of charge and measurement of the internal resistance in an arbitrary state of charge while changing the state of charge. The measurement of the open-circuit voltage and the internal resistance is preferably performed for a plurality of states of charge within the used voltage range of the secondary cell. The secondary cell to be diagnosed may include an electrode using an active material of a known type, or may include an electrode for which an active material of an unknown type is used.

The charge/discharge current for adjustment to a predetermined state of charge is preferably at least 10C or less, and more preferably 1C or less. When charging and discharging are performed at a low rate, a more accurate open-circuit voltage and internal resistance can be measured. The number of measurement points of the state of charge is preferably 10 points or more from the viewpoint of performing an accurate diagnosis, and is preferably from 10 points to 50 points from the viewpoint of reducing the number of measurements.

When the deterioration state is diagnosed, reference data indicating the relationship between the state of charge and the open-circuit potential of the electrode having a known deterioration state and reference data indicating the relationship between the state of charge and the internal resistance of the electrode having a known deterioration state are stored in the storage unit 20. These pieces of reference data may be represented by a relational expression or may be represented by a data table.

As the reference data, for example, data of an electrode in an initial state in which deterioration does not substantially progress can be used. The reference data can be obtained by actually measuring the open-circuit potential and the internal resistance of the electrode in the initial state in advance of diagnosing the deterioration state. The reference data is used as basic data to be applied to the measurement data of the secondary cell to be diagnosed when the deterioration state of the secondary cell to be diagnosed is broken down into the deterioration state for each electrode and evaluated.

The reference data is prepared for each of the positive electrode and the negative electrode electrodes. As the reference data, it is preferable to prepare a plurality of data for each type of active material used for the electrodes. As the reference data, it is preferable to prepare data of the various electrodes using an active material of a known type according to the type of the active material used in the secondary cell to be diagnosed and the type of active material assumed to be used in the secondary cell to be diagnosed.

Note that the measurement data and the reference data may be acquired through measurement in a charging process or may be acquired through measurement in a discharging process. However, in general, there is hysteresis in behavior in the charging process and behavior in the discharging process. Therefore, the measurement data and the reference data are preferably acquired through measurement in a mutually common process.

In addition, the measurement data and the reference data may be data indicating the relationship between the state of charge and the numerical value of the open-circuit potential, data indicating the relationship between the state of charge and the numerical value of the internal resistance, data indicating the relationship between the state of charge and the differential value of the open-circuit potential, or data indicating the relationship between the state of charge and the differential value of the internal resistance. The deterioration state can be diagnosed between pieces of data using differential values. When the differential value of the open-circuit potential is used, a relationship inversely proportional to the effective active material amount is obtained, and hence the correctness of the effective active material amount can be secured. When the differential value of the internal resistance is used, the influence of a constant voltage drop derived from the metal member or the like can be reduced.

As illustrated in FIG. 2, first, the arithmetic unit 10 reads, from the storage unit 20, measurement data indicating the relationship between the state of charge and the open-circuit voltage of the secondary cell to be diagnosed (step S1).

The measurement data indicating the relationship between the state of charge and the open-circuit voltage of the secondary cell can be obtained, for example, by measuring the open-circuit voltage in each state of charge while repeating the operation of charging or discharging the secondary cell to a predetermined state of charge, then charging or discharging the secondary cell at a minute constant current for a certain time, and pausing for a predetermined time until another predetermined state of charge is reached.

The measurement data indicating the relationship between the state of charge and the open-circuit voltage of the secondary cell is preferably measured by repeating charging for 5 seconds or more, discharging for 5 seconds or more, and pausing for 5 seconds or more. The time during which charging and discharging are suspended is preferably 10 minutes or more, and more preferably 30 minutes or more. When time for stopping charging and discharging is adequately secured, the electrochemical state of the active material and the movement of the charge carriers easily reach equilibrium, and hence a more accurate open-circuit voltage can be measured.

Subsequently, the arithmetic unit 10 reads, from the storage unit 20, reference data indicating the relationship between the state of charge and the open-circuit potential of the negative electrode having a known deterioration state and reference data indicating the relationship between the state of charge and the open-circuit potential of the positive electrode having a known deterioration state (step S2).

As the reference data indicating the relationship between the state of charge and the open-circuit potential, reference data of an arbitrary electrode among the positive electrode and the negative electrode, or reference data of an electrode using an arbitrary active material among various active materials can be read. Even if the type of the electrode and the type of the active material are unknown at this stage, the deterioration state of each electrode can be appropriately evaluated by converging the subsequent calculations. However, in a case where the type of the electrode or the type of the active material is known or can be predicted, it is preferable to read the reference data of the corresponding electrode. For an electrode using an active material having an open-circuit potential that changes even in a state of charge other than close to the fully charged state and close to the completely discharged state, the deterioration state of the secondary cell can be evaluated using the method disclosed in PTL 1. In the present embodiment, a case will be described in which $LiFePO_4$, which is an active material having a flat potential except close to the fully charged state and close to the completely discharged state, is used for the positive electrode, and graphite, which is an active material having a potential that changes even other than close to the fully charged state and close to the completely discharged state, is used for the negative electrode.

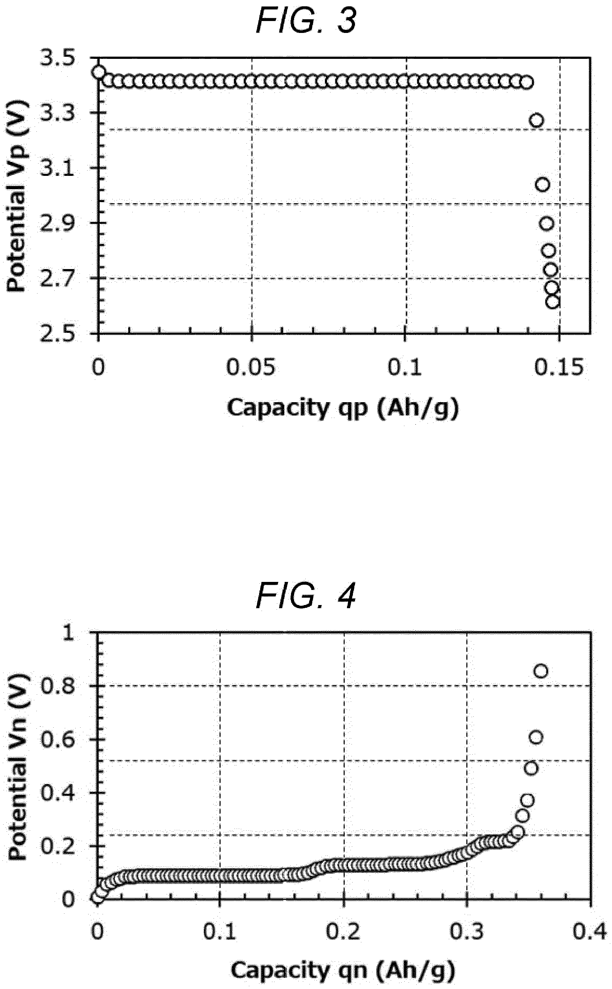

FIG. 3 is a diagram showing an example of the relationship between a state of charge and an open-circuit potential of an electrode.

FIG. 3 corresponds to reference data of a positive electrode using $LiFePO_4$ as an active material. The horizontal axis represents, as an example of the state of charge of the electrode, a discharge amount $qp$[Ah/g] from a fully charged state per unit mass of the positive electrode active material. The vertical axis represents the open-circuit potential $Vp$[V] of the positive electrode with respect to a reference electrode.

As shown in FIG. 3, in the active material in which the open-circuit potential is constant except close to the fully charged state and close to the completely discharged state, there is a plateau region in which the open-circuit potential does not substantially fluctuate with respect to a change in the state of charge of the electrode. Because the deterioration state of the electrode using such an active material is not reflected in the open-circuit potential, it is difficult to perform an evaluation on the basis of the relationship between the state of charge and the open-circuit potential of the electrode. Such an electrode is preferably evaluated on the basis of the relationship between the state of charge and the internal resistance of the electrode.

FIG. 4 is a diagram showing an example of the relationship between the state of charge and the open-circuit potential of an electrode.

FIG. 4 corresponds to reference data of a negative electrode that uses graphite as an active material. The horizontal axis represents, as an example of the state of charge of the electrode, a discharge amount qn[Ah/g] from a fully charged state per unit mass of the negative electrode active material. The vertical axis represents the open-circuit potential $V_n[V]$ of the negative electrode with respect to the reference electrode.

As shown in FIG. 4, in an active material in which the open-circuit potential is not constant except close to the fully charged state and close to the completely discharged state, the open-circuit potential fluctuates in response to a change in the state of charge of the electrode. Because the deterioration state of the electrode using such an active material is reflected in the open-circuit potential, the evaluation can be performed on the basis of the relationship between the state of charge and the open-circuit potential of the electrode. Based on the open-circuit potential, the deterioration state can be diagnosed more easily and accurately in comparison with a case based on the internal resistance, which is influenced by a large number of factors.

Subsequently, the arithmetic unit 10 provisionally sets a deterioration state parameter of the positive electrode, which is a counter electrode to the evaluation target electrode (step S3). In this step, deterioration state parameters related to capacitance that serve to correct the relationship between the state of charge and the open-circuit potential are provisionally set.

The deterioration state parameter is a parameter quantitatively representing a deterioration state of an electrode. As a deterioration state parameter related to capacitance, a coefficient or a constant of a state quantity representing the state of charge can be set, as a parameter representing a capacitance-dependent deterioration state, in a function representing the relationship between the state of charge and the open-circuit potential or a function representing the relationship between the state of charge and the internal resistance. For example, for the positive electrode, the positive electrode active material utilization rate mpr, the positive electrode out-of-range capacitance dp, and the like, can be set. For the negative electrode, the negative electrode active material utilization rate mnr, the negative electrode out-of-range capacitance dn, and the like, can be set.

The positive electrode active material utilization rate mpr represents the ratio of the positive electrode active material utilized for the charge-discharge reaction among the positive electrode active materials contained in the positive electrode. The positive electrode active material utilization rate mpr is expressed by mpr = mp/mp0, where the amount of the positive electrode active material contained in the positive electrode is mp0[g], and the amount of the positive electrode active material utilized in the charge-discharge reaction is mp[g].

The positive electrode out-of-range capacitance dp represents a capacitance, of the capacitance of the positive electrode, which can be obtained only in a state of charge higher than the fully charged state of the secondary cell. In a fully charged state in which the secondary cell reaches the upper limit voltage of the operating voltage range, the charging operation is stopped, but the actual positive electrode itself has room for charging equivalent to the positive electrode out-of-range capacitance dp. The capacitance Qp[Ah] of the positive electrode is represented by Qp = mp × qp_max, where mp[g] is the amount of the positive electrode active material utilized in the charge-discharge reaction, and qp_max[Ah/g] is the capacitance of the positive electrode per unit mass.

The negative electrode active material utilization rate mnr represents the ratio of the negative electrode active material utilized for the charge-discharge reaction of the negative electrode active material contained in the negative electrode. The negative electrode active material utilization rate mnr is expressed by mnr = mn/mn0, where the amount of the negative electrode active material contained in the negative electrode is mn0[g] and the amount of the negative electrode active material utilized in the charge-discharge reaction is mn[g].

The negative electrode out-of-range capacitance dn represents the capacitance, of the capacitance of the negative electrode, which can be obtained only in a state of charge higher than the fully charged state of the secondary cell. The capacitance Qn[Ah] of the negative electrode is represented by Qn = mn × qn_max, where mn[g] is the amount of the negative electrode active material utilized in the charge-discharge reaction, and qn_max[Ah/g] is the capacitance of the negative electrode per unit mass.

As deterioration state parameters related to capacitance, arbitrary numerical values for a predetermined interval are defined as an upper limit value and a lower limit value representing a state in which there is no deterioration of the electrode and a state in which the electrode has completely deteriorated. The deterioration state parameters related to capacitance may be associated on the data with a coefficient or a constant of a state quantity representing the state of charge or a degree of deterioration representing the deterioration state of the electrode. Such deterioration state parameters can be stored in the storage unit 20 as a parameter table.

Any value can be provisionally set as the deterioration state parameter related to capacitance of the counter electrode with respect to the electrode to be evaluated. Because the deterioration state of the counter electrode with respect to the electrode to be evaluated cannot be evaluated at this stage, an arbitrary value is provisionally set to evaluate the electrode to be evaluated. For example, it is possible to provisionally set mpr = 1, dp = 0, and the like, on the assumption that there is no deterioration, for the positive electrode which is a counter electrode to the electrode to be evaluated.

Subsequently, the arithmetic unit 10 sets a deterioration state parameter of the negative electrode which is the electrode to be evaluated (step S4). In this step, a deterioration state parameter related to capacitance and serving to correct the relationship between the state of charge and the open-circuit potential is set. Note that either step S3 or step S4 may be executed first.

An arbitrary value can be set as the deterioration state parameter related to capacitance of the electrode to be evaluated. As the deterioration state parameter of the electrode to be evaluated, a parameter representing a deterioration state corresponding to the deterioration state parameter of the counter electrode may be set, or any parameter independent of the counter electrode may be set. For example, mnr = 1, dn = 0, and the like can be set, on the assumption of no deterioration, for the negative electrode which is the electrode to be evaluated.

Subsequently, the arithmetic unit 10 generates calculation data indicating the relationship between the state of charge and the open-circuit voltage of the secondary cell on the basis of reference data indicating the relationship between the state of charge and the open-circuit potential of the negative electrode, reference data indicating the relationship between the state of charge and the open-circuit potential of the positive electrode, the set deterioration state parameters of the negative electrode, and the provisionally set deterioration state parameters of the positive electrode (step S5).

The relationship between the state of charge and the open-circuit voltage of the secondary cell can be calculated by combining functions of the open-circuit potential with respect to the state of charge by using the relationship between the state of charge and the open-circuit potential of the negative electrode and the relationship between the state of charge and the open-circuit potential of the positive electrode. The relationships between the state of charge and the open-circuit potential for each of the electrodes are corrected using the deterioration state parameters and then combined. When the correction is performed using the deterioration state parameters, calculation data indicating the behavior of the open-circuit voltage and for which a deterioration state is assumed is generated.

For example, when the discharge capacitance of the secondary cell from the fully charged state is Qc[Ah], the open-circuit voltage of the secondary cell in the state of charge x is Vc(x) [V], the open-circuit potential of the positive electrode in the state of charge x is Vp(x) [V], and the open-circuit potential of the negative electrode in the state of charge x is Vn(x) [V], the relationship between the state of charge and the open-circuit voltage of the secondary cell can be calculated by the following formulas (1) to (3).

$$\mathtt{Qc ~=~ mpr ~\times~ mp0 ~\times~ qp ~-~ dp ~\cdots~ (1)}$$

$$\mathtt{Qc ~=~ mnr ~\times~ mn0 ~\times~ qn ~-~ dn ~\cdots~ (2)}$$

$$\mathtt{Vc(Qc) ~=~ Vp(qp) ~-~ Vn(qn) ~\cdots~ (3)}$$

Subsequently, the arithmetic unit 10 compares the calculation data indicating the relationship between the state of charge and the open-circuit voltage of the secondary cell and calculated by assuming the deterioration state with the measurement data indicating the relationship between the state of charge and the open-circuit voltage of the secondary cell to be diagnosed (step S6). In the comparison processing, it is determined whether or not the calculation data assuming the deterioration state and the measurement data match (step S7).

The determination of whether the pieces of data match may be performed using an arbitrary determination method. For example, it can be performed on the basis of the residual sum of squares between data. The sum of squares of difference between the calculation data and the measurement data is calculated, and the sum of squares of difference is compared with an arbitrarily set threshold value to determine consistency between the data.

In a case where the discharge capacitance Qc is used as the state of charge, the calculation data indicating the relationship between the state of charge and the open-circuit voltage of the secondary cell is a set of discrete data obtained by combining a calculated value Qcc of the discharge capacitance from the fully charged state of the secondary cell and a calculated value Vcc of the open-circuit voltage of the secondary cell. A set of calculation data can be stored in the storage unit 20 as a data table. The data table of the calculation data includes data such as (Qcc_1, Vcc_1), (Qcc_2, Vcc_2), ···, and (Qcc_M, Vcc_M).

In a case where the discharge capacitance Qc is used as the state of charge, the measurement data indicating the relationship between the state of charge and the open-circuit voltage of the secondary cell to be diagnosed is a set of discrete data obtained by combining a measured value Qce of the discharge capacitance from the fully charged state of the secondary cell and a measured value Vce of the open-circuit voltage of the secondary cell. A set of measurement data can be stored in the storage unit 20 as a data table. The data table of the measurement data includes data such as (Qce_1, Vce_1), (Qce_2, Vce_2), ···, and (Qce_N, Vce_N).

In the determination of whether the pieces of data match, the calculation data corresponding to the state of charge of the measurement data is extracted from the data table of the calculation data. For the measurement data (Qce_1, Vce_1), (Qce_2, Vce_2), ···, and (Qce_N, Vce_N), the same or approximate calculation data (Qcc_1, Vcc_1), (Qcc_2, Vcc_2), ···, (Qcc_N, Vcc_N), and the like of the discharge capacitance Qc can be extracted.

The square of the difference between the calculated value in the calculation data and the measured value in the measurement data is calculated between the mutually corresponding data of the states of charge, and the square of the difference is summed among all the data. As the sum of squares of difference between the calculated values Vcc_1 to Vcc_N in the calculation data and the measured values Vce_1 to Vce_N in the measurement data, $\Sigma(Vcc\_i - Vce\_i)^2$ can be calculated for i = 1 to N.

The sum of squares of difference thus calculated is compared with a preset threshold value for consistency. As a threshold value for consistency of the open-circuit potentials, an arbitrary value can be set such that the degree of similarity between the pieces of data increases according to accuracy required for diagnosis, the number of calculation iterations, and the like. At the time of the sum of squares of difference is calculated, in a case where there is no calculation data for the discharge capacitance Qc corresponding to the measurement data, interpolation may be used to interpolate the calculation data corresponding to the measurement data.

As a result of the comparison, when the sum of squares of difference between the calculation data and the measurement data exceeds a preset threshold value, it can be determined that the calculation data indicating the relationship between the state of charge and the open-circuit voltage of the secondary cell, which is calculated by assuming a deterioration state, and the measurement data indicating the relationship between the state of charge and the open-circuit voltage of the secondary cell to be diagnosed do not match. In this case (step S7: NO), the deterioration state parameter of the electrode to be evaluated is reset, and the calculation data is regenerated and re-compared.

On the other hand, when, as a result of the comparison, the sum of squares of difference between the calculation data and the measurement data is equal to or less than a preset threshold value, it can be determined that the calculation data indicating the relationship between the state of charge and the open-circuit voltage of the secondary cell, which is calculated by assuming a deterioration state, and the measurement data indicating the relationship between the state of charge and the open-circuit voltage of the secondary cell to be diagnosed match. In this case (step S7: YES), the set deterioration state parameter of the electrode to be evaluated is adopted, and the deterioration state of the other electrode is evaluated.

The adopted deterioration state parameter is registered in the storage unit 20 in association with an identifier for identifying the secondary cell to be diagnosed or an identifier for identifying the electrode to be evaluated. Among the deterioration state parameters of the electrode to be evaluated, the deterioration state parameters related to capacitance for determining the open-circuit voltage, which are mnr and dn in the present embodiment, are determined using the above procedure, and the determined values are used in the subsequent procedure. Because the deterioration state parameter of the electrode to be evaluated is calculated by provisionally setting the deterioration state parameter of the counter electrode, the deterioration state parameter is updated according to the evaluation result of the deterioration state of the counter electrode.

Note that the resetting of the deterioration state parameter related to capacitance of one of the positive electrode and the negative electrode and regeneration and re-comparison of the calculation data based on the deterioration state parameter related to the reset capacitance can be repeated any number of times until it is determined that the calculation data and the measurement data match. As the deterioration state parameters related to capacitance, previously unset values can be sequentially set.

In addition, the determination of whether the pieces of data match can also be made by comparing a reduction range for each calculation of the sum of squares of difference between the calculation data and the measurement data with a predetermined threshold value instead of comparing the sum of squares of difference between the calculation data and the measurement data with a predetermined threshold value. For repetition of regeneration and re-comparison of calculation data, when a reduction range of the sum of squares of a current difference with respect to the sum of squares of the previous difference becomes a predetermined value or less, it can also be determined that the pieces of data match.

In a case where the calculation data and the measurement data for one of the positive electrode and the negative electrode do not match at a predetermined number of calculations or a predetermined calculation time, the diagnosis processing can be stopped. Alternatively, the reference data can be replaced with the reference data of an electrode using another active material, and the resetting of the deterioration state parameter related to capacitance, and the regeneration and re-comparison of the calculation data based on the reset deterioration state parameter can be performed again.

The reference data is preferably stored in the storage unit 20 as a database in association with identifiers for identifying the positive electrode and the negative electrode and identifiers for identifying the types of active materials used for the electrodes. When such a database is prepared, even if the type of the active material used in the secondary cell to be diagnosed is unknown, an appropriate evaluation can be performed through regeneration and re-comparison of calculation data in which the reference data has been replaced.

In a case where the type of active material used in the secondary cell to be diagnosed is unknown, in steps S1 to S5, the relationship between the state of charge and the open-circuit voltage of a secondary cell using an active material of a known type is obtained on the basis of the relationship between the state of charge and the open-circuit potential of the positive electrode using an active material of a known type and the relationship between the state of charge and the open-circuit potential of the negative electrode using an active material of a known type. Reference data indicating these relationships is read from the storage unit 20, and calculation data indicating the relationship between the state of charge and the open-circuit voltage of the secondary cell is generated.

Subsequently, in step S6, the calculation data indicating the relationship between the state of charge and the open-circuit voltage of the secondary cell using the active material of the known type is compared with the measurement data indicating the relationship between the state of charge and the open-circuit voltage of the secondary cell using the active material of the unknown type to specify the type of the active material for which the type is unknown.

As a result of the comparison, in a case where the calculation data and the measurement data match, it can be determined that the active material used in the secondary cell to be diagnosed is of the same type as the active material of the reference data. When the open-circuit potential of one of the positive electrode and the negative electrode is constant except close to the fully charged state and close to the completely discharged state, and the open-circuit potential of the other electrode is not constant from close to the fully charged state to close to the completely discharged state, diagnosis can be performed highly accurately. Therefore, the processing to evaluate the deterioration state for each electrode can be continued on the basis of the selected reference data and the set deterioration state parameters related to capacitance.

On the other hand, in a case where, as a result of the comparison, the calculation data and the measurement data do not match, it can be determined that the active material used in the secondary cell to be diagnosed is of a different type than the active material of the reference data. In this case, the reference data can be replaced with the reference data of the electrode using another active material, and the resetting of the deterioration state parameter related to capacitance, and the regeneration and re-comparison of the calculation data based on the reset deterioration state parameter can be performed again.

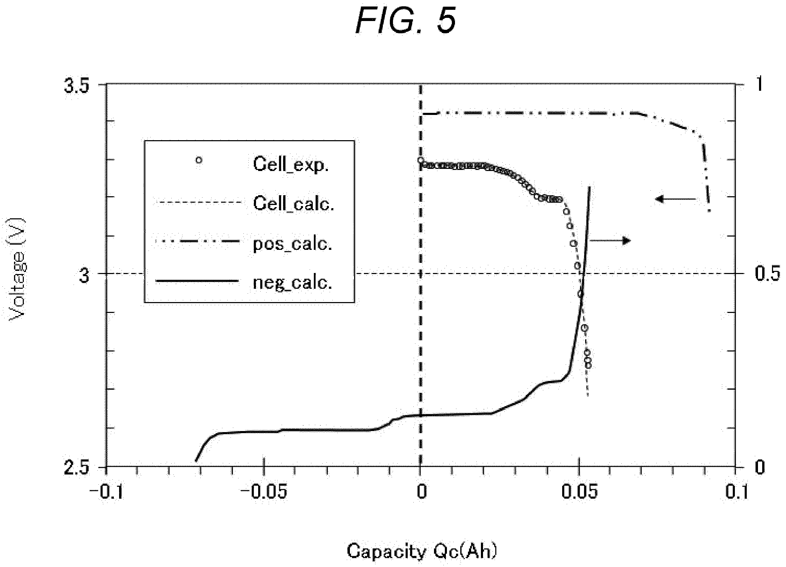

FIG. 5 is a diagram showing an example of the evaluation result of the relationship between the state of charge and the open-circuit potential of the secondary cell at the stage where the evaluation of one electrode is complete (at the end of step S7).

In FIG. 5, the horizontal axis represents the discharge capacitance [Ah] of the secondary cell or the electrode from the fully charged state. The vertical axis represents the open-circuit potential [V]. FIG. 5 illustrates the result (see steps S1 to S7) of evaluating the deterioration state of the negative electrode by using a secondary cell in which the deterioration has progressed as a diagnosis target. The secondary cell to be diagnosed is used until the discharge capacitance reaches about 0.04Ah.

In FIG. 5, the plot represents measurement results indicating the relationship between the state of charge and the open-circuit voltage of the secondary cell. The broken line represents a computation result indicating the relationship between the state of charge and the open-circuit voltage of the secondary cell. The two-dot chain line represents a reference result indicating the relationship between the state of charge and the open-circuit potential of the positive electrode. However, at this stage, the deterioration state parameter related to capacitance of the positive electrode is a provisionally set value, and the relationship between the state of charge and the open-circuit potential of the positive electrode is also provisional. The solid line represents a reference result indicating the relationship between the state of charge and the open-circuit potential of the negative electrode. The deterioration state parameter related to capacitance of the negative electrode is determined at this stage, and the relationship between the state of charge and the open-circuit potential of the negative electrode is also determined.

As illustrated in FIG. 5, when the open-circuit voltage is measured for the secondary cell to be diagnosed while changing the state of charge, a measurement result (see plot) indicating the relationship between the state of charge and the open-circuit voltage of the secondary cell to be diagnosed is obtained. The open-circuit voltage of the secondary cell is periodically measured at micro-time intervals until the discharge capacitance reaches about 0.04Ah, but is measured at the time of diagnosis after about 0.04Ah.

In addition, when Formula (3) is calculated on the basis of the reference result (see the two-dot chain line) indicating the relationship between the state of charge and the open-circuit potential of the positive electrode and the reference result (see the solid line) indicating the relationship between the state of charge and the open-circuit potential of the negative electrode, a calculation result (see the broken line) indicating the relationship between the state of charge and the open-circuit voltage of the secondary cell is obtained. When the deterioration state parameter related to capacitance is set, the curve can be shifted along the capacitance axis, as indicated by the arrow in FIG. 5. Because the calculation data corrected by the deterioration state parameter is fitted to the measurement data, deterioration of the charge/discharge capacitance can be particularly diagnosed.

After the deterioration state parameter related to capacitance of one electrode is registered, the arithmetic unit 10 reads the measurement data indicating the relationship between the state of charge and the internal resistance of the secondary cell to be diagnosed from the storage unit 20 (step S8).

The measurement data indicating the relationship between the state of charge and the internal resistance of the secondary cell can be obtained by measuring the internal resistance in each state of charge while repeating the operation of charging or discharging the secondary cell to a predetermined state of charge, then charging or discharging the secondary cell with a minute constant current for a certain period of time, and pausing for a predetermined period of time until another predetermined state of charge is reached.

The measurement data indicating the relationship between the state of charge and the internal resistance of the secondary cell is preferably measured by repeating charging for 5 seconds or more, discharging for 5 seconds or more, and pausing for 5 seconds or more. The internal resistance is preferably obtained on the basis of a closed circuit voltage when five seconds or more have elapsed since the start of energization from an open circuit state, and is more preferably obtained on the basis of the closed circuit voltage when 30 seconds or more have elapsed. The longer the energization time for measuring the internal resistance, the more easily the electrochemical state of the active material and the voltage change accompanying the diffusion of charge carriers are reflected in the measurement results, and hence the internal resistance can be measured more accurately.

Subsequently, the arithmetic unit 10 reads, from the storage unit 20, reference data indicating the relationship between the state of charge and the internal resistance of a positive electrode having a known deterioration state, and reference data indicating the relationship between the state of charge and the internal resistance of the negative electrode having a known deterioration state (step S9).

As the reference data indicating the relationship between the state of charge and the internal resistance, both the electrode evaluated thus far and the reference data of the counter electrode are read. As the reference data, reference data of an electrode using an arbitrary active material among various active materials can be read. However, in a case where the type of the electrode or the type of the active material is known or can be predicted, it is preferable to read the reference data of the corresponding electrode.

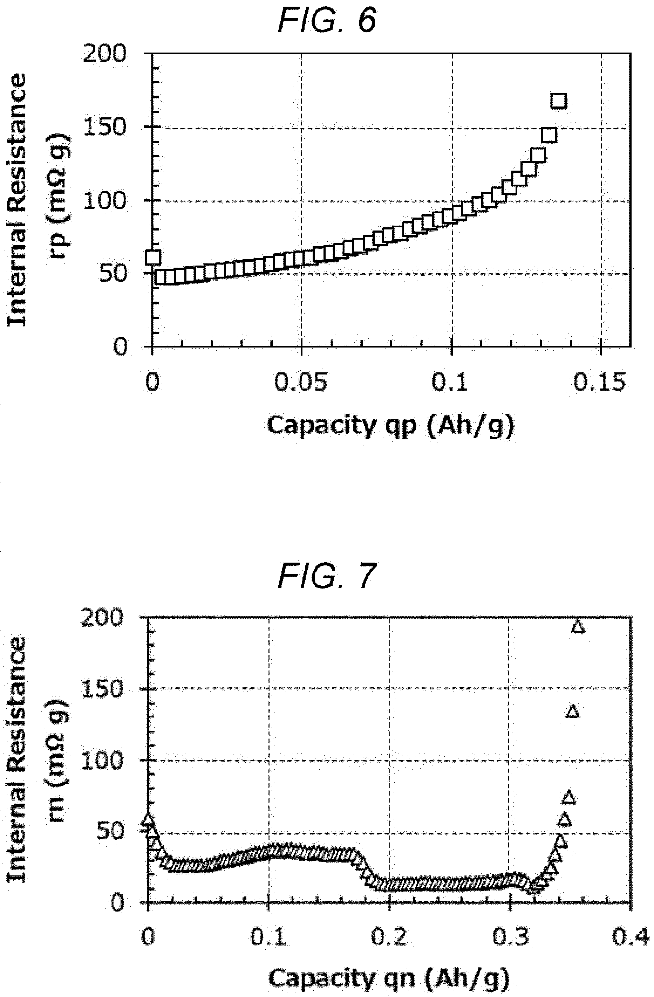

FIG. 6 is a diagram illustrating an example of the relationship between a state of charge and internal resistance of an electrode.

FIG. 6 corresponds to the reference data of the positive electrode using $LiFePO_4$ as the active material. The horizontal axis represents, as an example of the state of charge of the electrode, a discharge amount $qp[Ah/g]$ from a fully charged state per unit mass of the positive electrode active material. The vertical axis represents the internal resistance $Rp$ (product of mass resistivity and surface area) $[m\Omega \cdot g]$ of the positive electrode.

As can be seen from a comparison between FIG. 6 and FIG. 3, even when the open-circuit potential is constant, the internal resistance continuously fluctuates in response to a change in the state of charge of the electrode. The deterioration state of the electrode using such an active material can be diagnosed on the basis of the relationship between the state of charge and the internal resistance of the electrode. Based on the internal resistance, it is possible to diagnose the deterioration state, which is difficult in the case of being based on the open-circuit potential in which the resistance factor is not reflected.

FIG. 7 is a diagram showing an example of the relationship between the state of charge and internal resistance of an electrode.

FIG. 7 corresponds to reference data of a negative electrode that uses graphite as an active material. The horizontal axis represents, as an example of the state of charge of the electrode, a discharge amount $qn[Ah/g]$ from a fully charged state per unit mass of the negative electrode active material. The vertical axis represents the internal resistance $Rn$ (product of mass resistivity and area) $[m\Omega \cdot g]$ of the negative electrode.

As can be seen from a comparison between FIG. 7 and FIG. 4, in the negative electrode using graphite, the open-circuit potential and the internal resistance fluctuate with respect to a change in the state of charge of the electrode according to the state of charge. When the relationship between the state of charge and the internal resistance of the secondary cell is diagnosed, it is necessary to utilize the relationship between the state of charge and the internal resistance of the positive electrode and the negative electrode.

Subsequently, the arithmetic unit 10 sets a deterioration state parameter related to capacitance of the positive electrode which is the electrode to be evaluated (step S10). In addition, as the deterioration state parameter related to capacitance of the negative electrode, which is a counter electrode to the electrode to be evaluated, the deterioration state parameter registered in the previous steps is set. In addition, deterioration state parameters related to internal resistance, which have not been determined in the previous steps, are set.

Examples of the parameters for the deterioration state that have not been determined in the previous step include a deterioration state parameter related to capacitance of the electrode to be evaluated and other deterioration state parameters. Other deterioration state parameters include deterioration state parameters related to internal resistance corresponding to the internal resistances of the positive electrode, the negative electrode, and members other than the positive electrode and the negative electrode. As the deterioration state parameters related to internal resistance, a coefficient of a resistance term for each electrode dependent on the state of charge or a constant corresponding to the internal resistance of a member other than the positive electrode and the negative electrode can be set in a function indicating the relationship between the state of charge and the internal resistance. For example, an internal resistance $R0$ of members other than the positive electrode and the negative electrode, a correction coefficient $ap$ for the internal resistance of the positive electrode, the correction coefficient $an$ for the internal resistance of the negative electrode, and the like, can be set.

Any values can be provisionally set as the deterioration state parameters related to capacitance or the deterioration state parameters related to internal resistance of the electrode to be evaluated. For example, it is possible to set mpr = 1, dp = 0, or the like by assuming no deterioration for the positive electrode which is an electrode to be evaluated. In addition, as the internal resistance R0 of a member other than the positive electrode and the negative electrode, a value between 0 and the internal resistance of the secondary cell can be set. In addition, a value of 0 or more can be set as the correction coefficients ap and an of the internal resistances of the positive electrode and the negative electrode.

Subsequently, the arithmetic unit 10 generates calculation data indicating the relationship between the state of charge and the internal resistance of the secondary cell on the basis of the reference data indicating the relationship between the state of charge and the internal resistance of the positive electrode, reference data indicating the relationship between the state of charge and the internal resistance of the negative electrode, the set deterioration state parameter, and the registered deterioration state parameter (step S11).

The relationship between the state of charge and the internal resistance of the secondary cell can be calculated by combining functions of the internal resistance with respect to the state of charge by utilizing the relationship between the state of charge and the internal resistance of the positive electrode and the relationship between the state of charge and the internal resistance of the negative electrode. The relationships between the state of charge and the internal resistance for each of the electrodes are corrected using the deterioration state parameters and then combined. When the correction is performed using the deterioration state parameters, calculation data indicating the behavior of the internal resistance for which a deterioration state is assumed is generated.

For example, when the discharge capacitance of the secondary cell from the fully charged state is Qc[Ah], the internal resistance of the secondary cell in the state of charge x is Rc(x) [Ω], the internal resistance of the positive electrode in the state of charge x is rp(x)[Ω·g], the internal resistance of the negative electrode in the state of charge x is rn(x)[Ω·g], the internal resistance of members other than the positive electrode and the negative electrode is R0[Ω], the correction coefficient of the internal resistance of the positive electrode is ap, and the correction coefficient of the internal resistance of the negative electrode is an, the relationship between the state of charge and the internal resistance of the secondary cell can be calculated by the following formulas (1) to (2), and (4).

$$Qc = mpr \times mp0 \times qp - dp \cdots (1)$$

$$Qc = mnr \times mn0 \times qn - dn \cdots (2)$$

$$Rc(Qc) = R0 + ap/(mpr \times mp0) \times rp(qp)$$

$$+ an/(mnr \times mn0) \times rn(qn) \cdots (4)$$

Subsequently, the arithmetic unit 10 compares the calculation data indicating the relationship between the state of charge and the internal resistance of the secondary cell calculated assuming the deterioration state with the measurement data indicating the relationship between the state of charge and the internal resistance of the secondary cell to be diagnosed (step S12). In the comparison processing, it is determined whether or not the calculation data, for which a deterioration state is assumed, and the actually measured measurement data match (step S13).

The determination of whether the pieces of data match may be performed using an arbitrary determination method. For example, it can be performed on the basis of the residual sum of squares between data. The sum of squares of difference between the calculation data and the measurement data is calculated, and the sum of squares of difference is compared with an arbitrarily set threshold value to determine consistency between the data.

In a case where the discharge capacitance Qc is used as the state of charge, the calculation data indicating the relationship between the state of charge and the internal resistance of the secondary cell is a set of discrete data obtained by combining the calculation value Qcc of the discharge capacitance from the fully charged state of the secondary cell and the calculation value Rcc of the internal resistance of the secondary cell. A set of calculation data can be stored in the storage unit 20 as a data table. The data table of the calculation data includes data such as (Qcc_1, Rcc_1), (Qcc_2, Rcc_2), ⋯, and (Qcc_M, Rcc_M).

In a case where the discharge capacitance Qc is used as the state of charge, the measurement data indicating the relationship between the state of charge and the internal resistance of the secondary cell to be diagnosed is a set of discrete data obtained by combining a measured value Qce of the discharge capacitance from the fully charged state of the secondary cell and the measured value Rce of the internal resistance of the secondary cell. A set of measurement data can be stored in the storage unit 20 as a data table. The data table of the measurement data includes data such as (Qce_1, Rce_1), (Qce_2, Rce_2), ⋯, and (Qce_N, Rce_N).

In the determination of whether the pieces of data match, the calculation data corresponding to the state of charge of the measurement data is extracted from the data table of the calculation data. For the measurement data (Qce_1, Rce_1), (Qce_2, Rce_2), ···, and (Qce_N, Rce_N), the same or approximate calculation data (Qcc_1, Rcc_1), (Qcc_2, Rcc_2), ···, (Qcc_N, Rcc_N), and the like of the discharge capacitance Qc can be extracted.

The square of the difference between the calculated value in the calculation data and the measured value in the measurement data is calculated between the mutually corresponding data of the states of charge, and the square of the difference is summed among all the data. As the sum of squares of difference between the calculated values Rcc_1 to Rcc_N in the calculation data and the measured values Rce_1 to Rce_N in the measurement data, $\sum(Rcc\_i - Rce\_i)^2$ can be calculated for i = 1 to N.

The sum of squares of difference thus calculated is compared with a preset threshold value for consistency. As the threshold value for consistency of internal resistance, an arbitrary value can be set such that the degree of similarity between the data is increased according to the accuracy required for diagnosis, the number of calculation iterations, and the like. At the time of the sum of squares of difference is calculated, in a case where there is no calculation data for the discharge capacitance Qc corresponding to the measurement data, interpolation may be used to interpolate the calculation data corresponding to the measurement data.

As a result of the comparison, when the sum of squares of difference between the calculation data and the measurement data exceeds a preset threshold value, it can be determined that the calculation data indicating the relationship between the state of charge and the internal resistance of the secondary cell, which is calculated by assuming a deterioration state, and the measurement data indicating the relationship between the state of charge and the internal resistance of the secondary cell to be diagnosed do not match. In this case (step S13: NO), the deterioration state parameter is reset, and the calculation data is regenerated and re-compared.

On the other hand, when, as a result of the comparison, the sum of squares of difference between the calculation data and the measurement data is equal to or less than the preset threshold value, it can be determined that the calculation data indicating the relationship between the state of charge and the internal resistance of the secondary cell, which is calculated by assuming a deterioration state, and the measurement data indicating the relationship between the state of charge and the internal resistance of the secondary cell to be diagnosed match. In this case (step S13: YES), the provisionally set deterioration state parameter is adopted, and the evaluation of the deterioration state for each electrode is terminated.

The adopted deterioration state parameter is registered in the storage unit 20 in association with an identifier for identifying the secondary cell to be diagnosed or an identifier for identifying the electrode to be evaluated. The deterioration state parameters related to capacitance and the deterioration state parameters related to internal resistance adopted for each of the positive electrode and negative electrode electrodes are registered in association with each other.

When the evaluation of the deterioration state for each electrode is complete, the output unit 40 displays the diagnosis results of the deterioration states for each electrode. As the diagnosis results of the deterioration states for each electrode, calculation data indicating the relationship between the state of charge and the open-circuit potential of the electrode as corrected using the adopted deterioration state parameters, and calculation data indicating the relationship between the state of charge and the internal resistance of the electrode as corrected by the adopted deterioration state parameter can be displayed as a graph, a table, or the like, for each of the positive electrode and negative electrode electrodes.

In addition, the output unit 40 can display the diagnosis result of the deterioration state of the secondary cell synthesized on the basis of the diagnosis results for each of the electrodes. As the diagnosis result of the deterioration state of the secondary cell, calculation data indicating the relationship between the state of charge and the open-circuit voltage of the secondary cell combined using the calculation data for each electrode, and calculation data indicating the relationship between the state of charge and the internal resistance of the secondary cell combined using the calculation data for each electrode can be displayed as a graph, a table, or the like.

The output unit 40 may display the types of the active materials used for the electrodes, the degree of similarity indicating consistency between the calculation data and the measurement data, and the like, together with the calculation data indicating the deterioration states for each of the electrodes. In addition, the degree of deterioration corresponding to the value of a deterioration state parameter may be converted into a percentage display or the like and displayed. Furthermore, only the final result based on the adopted deterioration state parameter may be displayed, or an intermediate result for each calculation iteration may be displayed together with the final result.

The resetting of the deterioration state parameter related to capacitance of the other electrode of the positive electrode and the negative electrode, the resetting of the deterioration state parameter related to internal resistance, and the regeneration and re-comparison of the calculation data based on the reset deterioration state parameter can be repeated any number of times until it is determined that the calculation data and the measurement data match. As the deterioration state parameters related to capacitance and the deterioration state parameters related to internal resistance, previously unset values can be sequentially set.

In addition, the determination of whether the pieces of data match can also be made by comparing a reduction range for each calculation of the sum of squares of difference between the calculation data and the measurement data with a predetermined threshold value instead of comparing the sum of squares of difference between the calculation data and the measurement data with a predetermined threshold value. For repetition of regeneration and re-comparison of calculation data, when a reduction range of the sum of squares of a current difference with respect to the sum of squares of the previous difference becomes a predetermined value or less, it can also be determined that the pieces of data match.

In a case where the calculation data and the measurement data for the other electrode of the positive electrode and the negative electrode do not match at a predetermined number of calculations or a predetermined calculation time, the diagnosis processing can be stopped. Alternatively, the reference data can be replaced with the reference data of the electrode using another active material, and the resetting of the deterioration state parameter, and the regeneration and re-comparison of the calculation data based on the reset deterioration state parameter can be performed again. The evaluation based on the open-circuit voltage may be performed again using the deterioration state parameters which were set based on the internal resistance.

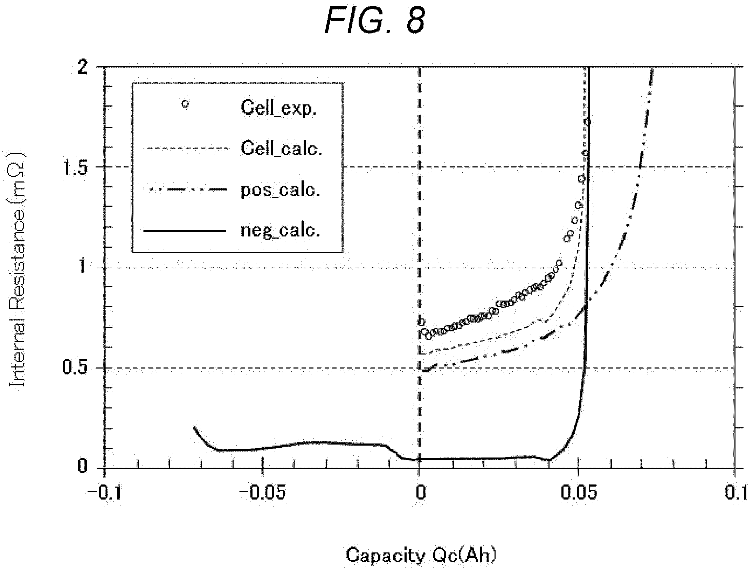

FIG. 8 is a diagram illustrating an example of a calculation result of the relationship between the state of charge and the internal resistance of the secondary cell at the stage where the deterioration state of the other electrode is assumed (at the end of step S11).

In FIG. 8, the horizontal axis represents the discharge capacitance [Ah] of the secondary cell or the electrode from the fully charged state. The vertical axis represents the internal resistance ($\Omega$). FIG. 8 illustrates a calculation result (see steps S8 to S11) obtained by determining, for the secondary cell to be diagnosed illustrated in FIG. 5, the relationship between the state of charge and the internal resistance of the secondary cell by assuming a deterioration state of the positive electrode.

In FIG. 8, the plot shows measurement results indicating the relationship between the state of charge and the internal resistance of the secondary cell. The broken line indicates a calculation result indicating the relationship between the state of charge and the internal resistance of the secondary cell. The two-dot chain line indicates a reference result indicating the relationship between the state of charge and the internal resistance of the positive electrode. The solid line indicates a reference result indicating the relationship between the state of charge and the internal resistance of the negative electrode. However, at this stage, the constant R0 and the correction coefficients ap and an are provisionally set values, and the relationship between the state of charge and the internal resistance of the positive electrode and the relationship between the state of charge and the internal resistance of the negative electrode are also provisional.

As illustrated in FIG. 8, when the internal resistance of the secondary cell to be diagnosed is measured while the state of charge is changed, measurement results (see the plot) indicating the relationship between the state of charge and the internal resistance of the secondary cell to be diagnosed is obtained. The internal resistance of the secondary cell is periodically measured at micro-time intervals until the discharge capacitance reaches about 0.04Ah, but is measured at the time of diagnosis after about 0.04Ah.

In addition, when Formula (4) is calculated on the basis of the reference results (see the two-dot chain line) indicating the relationship between the state of charge and the internal resistance of the positive electrode and the reference results (see the solid line) indicating the relationship between the state of charge and the internal resistance of the negative electrode, calculation results (see the broken line) indicating the relationship between the state of charge and the internal resistance of the secondary cell are obtained. At this stage, due to the fact that the deterioration state parameters of the positive electrode differ from the true values, there is a large difference between the secondary cell and the calculation results indicating the relationship between the state of charge and the internal resistance of the secondary cell. When the deterioration state parameter mpr of the positive electrode is to be adjusted, the calculation results indicating the relationship between the state of charge and the internal resistance of the positive electrode can be enlarged or reduced in the capacitance axis direction and the resistance axis direction. Adjusting the correction coefficients ap and an can also shift the curve along the resistance axis.

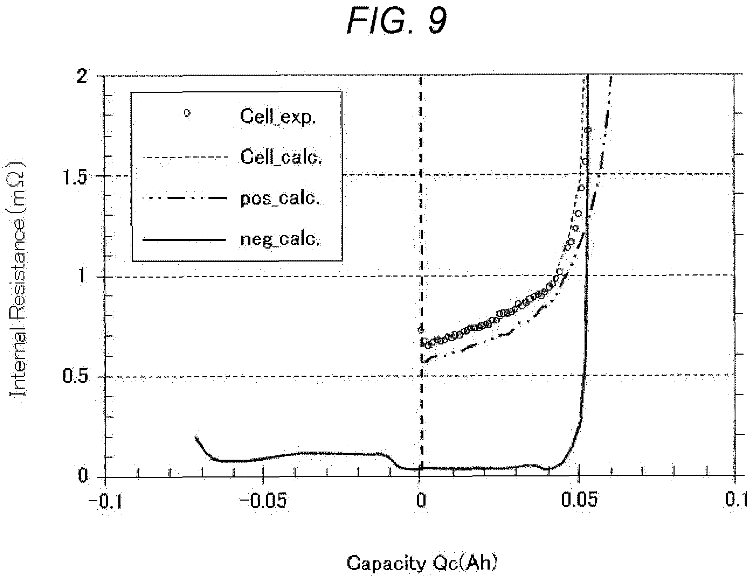

FIG. 9 is a diagram showing an example of the evaluation result of the relationship between the state of charge and the internal resistance of the secondary cell at the stage where the evaluation of the other electrode is complete (at the end of step S13).

In FIG. 9, the horizontal axis represents the discharge capacitance [Ah] of the secondary cell or the electrode from the fully charged state. The vertical axis represents the internal resistance [$\Omega$]. FIG. 9 illustrates the result of optimizing the deterioration state parameters of the positive electrode on the basis of the internal resistance by repeating resetting, recalculation, and re-comparison for the secondary cell to be diagnosed illustrated in FIG. 8.

In FIG. 9, the plot shows measurement results indicating the relationship between the state of charge and the internal resistance of the secondary cell. The broken line indicates a calculation result indicating the relationship between the state of charge and the internal resistance of the secondary cell. The two-dot chain line indicates a reference result indicating the relationship between the state of charge and the internal resistance of the positive electrode. The solid line indicates a reference result indicating the relationship between the state of charge and the internal resistance of the negative electrode.

As illustrated in FIG. 9, when, for the secondary cell to be diagnosed, the deterioration state parameters of the electrodes are optimized on the basis of the internal resistance by repeating resetting, recalculation, and re-comparison, the reference result (see the two-dot chain line) indicating the relationship between the state of charge and the internal resistance of the positive electrode can be shifted along the capacitance axis. In FIG. 9, the reference results (see the two-dot chain line) indicating the relationship between the state of charge and the internal resistance of the positive electrode are shifted to the low discharge amount side (left side) in comparison with FIG. 8.

The calculation data (see the broken line) indicating the relationship between the state of charge and the internal resistance of the secondary cell matches the measurement results (see the plot) indicating the relationship between the state of charge and the internal resistance of the secondary cell to be diagnosed by repeating the resetting, recalculation, and re-comparison of the deterioration state parameters. When the deterioration state parameters are set, the calculation data corrected by the deterioration state parameters are easily fitted to the measurement data, and thus the deterioration state of an electrode using an active material in which the open-circuit potential is not constant from close to the fully charged state to close to the completely discharged state can be easily estimated.

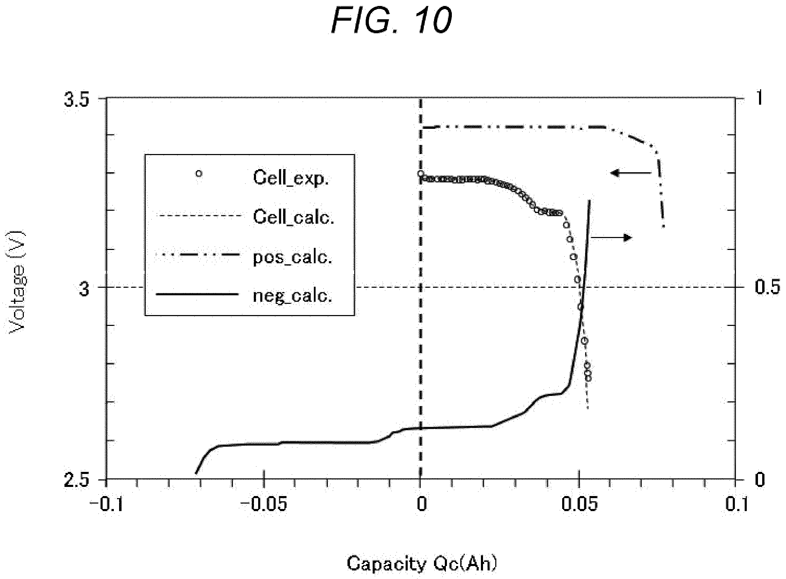

FIG. 10 is a diagram showing an example of the relationship between the state of charge and the open-circuit potential of the secondary cell.

In FIG. 10, the horizontal axis represents the discharge capacitance [Ah] of the secondary cell or the electrode from the fully charged state. The vertical axis represents the open-circuit potential [V]. FIG. 10 illustrates the result of optimizing, for the secondary cell to be diagnosed illustrated in FIG. 9, the deterioration state parameters of the positive electrode on the basis of the internal resistance and then optimizing the deterioration state parameters of the positive electrode again on the basis of the open-circuit voltage.

In FIG. 10, the plot shows measurement results showing the relationship between the state of charge and the open-circuit voltage of the secondary cell. The broken line represents a computation result indicating the relationship between the state of charge and the open-circuit voltage of the secondary cell. The two-dot chain line represents a reference result indicating the relationship between the state of charge and the open-circuit potential of the positive electrode. The solid line represents a reference result indicating the relationship between the state of charge and the open-circuit potential of the negative electrode.

As illustrated in FIG. 10, when the deterioration state parameter of the electrode of the secondary cell to be diagnosed is optimized again based on the open-circuit potential by repeating resetting, recalculation, and re-comparison, the reference result (see the two-dot chain line) indicating the relationship between the state of charge and the open-circuit potential of the positive electrode can be shifted along the capacitance axis. In FIG. 10, the reference results (see the two-dot chain line) indicating the relationship between the state of charge and the open-circuit potential of the positive electrode are shifted to the low discharge amount side (left side) in comparison with FIG. 5.

Because the internal resistance is not reflected in the relationship between the state of charge and the open-circuit voltage of the secondary cell, it is difficult to diagnose the deterioration state for each electrode highly accurately based only on the relationship between the state of charge and the open-circuit voltage of the secondary cell. However, for the electrode using the active material in which the open-circuit potential is not constant from close to the fully charged state to close to the completely discharged state, when the deterioration state parameters are optimized on the basis of the internal resistance and then optimized again on the basis of the open-circuit potential, the accuracy of the deterioration state diagnosis can be improved.

According to the secondary cell state diagnosis method and the secondary cell state diagnosis device described above, because the relationship between the state of charge and the open-circuit potential of the electrode and the relationship between the state of charge and the internal resistance of the electrode are used in the diagnosis of the deterioration states of each of the electrodes, the deterioration state of the secondary cell and the deterioration states of each electrode can be diagnosed highly accurately even in a case where an electrode using an active material in which potential does not change in response to a change in the state of charge is provided as one of the positive electrode and the negative electrode. Because the measurement result of the open-circuit voltage of the secondary cell to be diagnosed and the measurement result of the internal resistance of the secondary cell to be diagnosed are used in the diagnosis of the deterioration states of each of the electrodes, the deterioration states of the secondary cell or each electrode can be diagnosed in a non-destructive manner.

In the secondary cell state diagnosis method and the secondary cell state diagnosis device described above, the deterioration state evaluation results for each electrode can be used to change the post-diagnosis operating conditions range of the secondary cell. The post-diagnosis operating conditions range of the secondary cell is changed using a history of diagnosis results which are accumulated due to the diagnosis processing.

When the evaluation of the deterioration states of each of the electrodes is complete, one or more of the evaluation results of the deterioration states of each electrode and the evaluation results of the deterioration states of the secondary cell calculated on the basis of the evaluation results of the deterioration states of each electrode can be stored in the storage unit 20 for each diagnosis. These evaluation results can be collected by performing the diagnosis at different times on the same secondary cell to be analyzed. These evaluation results can be stored in the storage unit 20 as time-series evaluation results data.

Examples of the evaluation results data include the adopted deterioration state parameters, calculation data indicating the relationship between the state of charge and the open-circuit potential of the electrodes as corrected using the adopted deterioration state parameters, calculation data indicating the relationship between the state of charge and the internal resistance of the electrodes as corrected using the adopted deterioration state parameters, calculation data indicating the relationship between the state of charge and the open-circuit voltage of the secondary cell combined using the calculation data for each electrode, and calculation data indicating the relationship between the state of charge and the internal resistance of the secondary cell combined using the calculation data for each electrode.

The evaluation results data can be accumulated in the storage unit 20 in association with information such as the date and time of diagnosis, the secondary cell usage time, the amount of cumulative energization of the secondary cell, and the like. As the usage time of the secondary cell, the time from the initial charge/discharge of the secondary cell to be diagnosed to the present time, the number of charge/discharge cycles, and the like, can be inputted to the state diagnosis device 100. As the cumulative energization amount of the secondary cell, the energization amount obtained by adding the operating time of the secondary cell and the energization amount from the time of the initial reception/discharge of the secondary cell to the present time as calculated on the basis of the rated current can be inputted to the state diagnosis device 100.

One or more of the accumulated evaluation results of the deterioration states of each electrode and the evaluation results of the deterioration state of the secondary cell calculated on the basis of the evaluation results of the deterioration states of each electrode are read by the arithmetic unit 10 in order to change the post-diagnosis operating conditions of the secondary cell. Examples of the operating conditions of the secondary cell include an upper limit and a lower limit of a state of charge of the secondary cell, an upper limit and a lower limit of a charge current to the secondary cell, and an upper limit and a lower limit of a discharge current from the secondary cell. One or more of these operating conditions can be changed on the basis of the accumulated evaluation results data.

The post-diagnosis operating conditions of the secondary cell can be changed by using, as an index, (1) the deterioration state of each electrode, (2) the rate of change in the deterioration state of each electrode, or (3) the remaining life of the secondary cell. These indices are compared with predetermined threshold values, and when it is determined that progression of the deterioration of each electrode or the deterioration of the secondary cell is highly likely, the operating conditions range of the secondary cell is changed to conditions ensuring safety.

(1) As the deterioration state for each electrode, the latest deterioration state parameter registered in the above processing can be used as an index. When the degree of deterioration of the positive electrode represented by the deterioration state parameter related to capacitance, the degree of deterioration of the negative electrode represented by the deterioration state parameter related to capacitance, or the degree of resistance increase represented by the deterioration state parameter related to internal resistance is equal to or greater than a preset threshold value, the operating conditions range of the secondary cell can be changed to conditions ensuring safety.

(2) As the rate of change in the deterioration state for each electrode, the rate of change (change rate) with respect to a cumulative load amount of the deterioration state of the positive electrode or the rate of change (change rate) with respect to the cumulative load amount of the deterioration state of the negative electrode can be used as an index. When the degree of deterioration of the positive electrode represented by the deterioration state parameter related to capacitance, the degree of deterioration of the negative electrode represented by the deterioration state parameter related to capacitance, or the degree of resistance increase represented by the deterioration state parameter related to internal resistance is equal to or greater than a preset threshold value in response to the application of the predetermined cumulative load amount, the operating conditions range of the secondary cell can be changed to conditions ensuring safety.

The cumulative load amount can be calculated from a usage time of the secondary cell, an amount of energization of the secondary cell, or a combination of two or more of the usage time, the energization amount, a temperature, and a current. A model function indicating the relationship between the cumulative load amount and the deterioration states of the electrodes is formulated using, as variables, one or more of the usage time and the energization amount of the secondary cell, the temperature, and the current. The deterioration states of the electrodes with respect to various cumulative load amounts is actually measured, and the coefficient and the constant of the model function can be obtained by performing fitting using the actual measurement results.

(3) As the remaining life of the secondary cell, the usage time of the secondary cell until the discharge capacity of the secondary cell decreases to a predetermined discharge capacity due to the progress of deterioration can be used as an index. When the remaining life of the secondary cell is equal to or less than a preset threshold value with respect to an assumed predetermined usage time, the operating conditions range of the secondary cell can be changed to conditions ensuring safety.

The rate of change (change rate) of the deterioration state of the secondary cell with respect to the cumulative load amount is calculated on the basis of the rate of change (change rate) of the deterioration state of the positive electrode with respect to the cumulative load amount and the rate of change (change rate) of the deterioration state of the negative electrode with respect to the cumulative load amount, and the usage time of the secondary cell until the discharge capacity decreases to the predetermined discharge capacity can be estimated on the basis of the rate of change (change rate) of the deterioration state of the secondary cell with respect to the cumulative load amount, the current discharge capacity of the secondary cell, and the discharge capacity at the end of the life of the secondary cell.

Examples of operations for changing the operating conditions of the secondary cell to conditions ensuring safety include a change to lower the upper limit of the state of charge of the secondary cell, a change to raise the lower limit of the state of charge of the secondary cell, a change to lower the upper limit or the lower limit of the charge current to the secondary cell, and a change to lower the upper limit or the lower limit of the discharge current from the secondary cell.

When this post-diagnosis changing of the operating conditions range of the secondary cell is performed, the progress of the deterioration of the secondary cell can be suppressed, and thus the life of the secondary cell can be extended. Because the history of diagnosis results used to change the operating conditions range of the secondary cell is obtained as data indicating the deterioration states of each of the electrodes by means of the above-described secondary cell state diagnosis method and secondary cell state diagnosis device, it is possible to detect the deterioration of either the positive electrode or the negative electrode at an early stage and secure the safety of the secondary cell.

Although an embodiment of the present invention has been described above, the present invention is not limited to or by the above-described embodiment, For example, the present invention is not necessarily limited to an embodiment having all the configurations included in the above-described embodiment. A part of the configuration of a certain embodiment can be replaced with another configuration, a part of the configuration of a certain embodiment can be added to another embodiment, or a part of the configuration of a certain embodiment can be omitted, the scope of the invention being defined by the appended claims.

Reference Signs List

100 state diagnosis device (secondary cell state diagnosis device)
10 arithmetic unit
20 storage unit
30 input unit
40 output unit
50 communication unit

**Claims**

1. A secondary cell state diagnosis method for diagnosing a deterioration state of a secondary cell, the method comprising:

   receiving (S1) measurement data indicating a relationship between a state of charge and an open-circuit voltage of the secondary cell;
   receiving (S9) measurement data indicating a relationship between a state of charge and an internal resistance of the secondary cell;
   calculating (S5), for one electrode of a positive electrode and a negative electrode, a relationship between a state of charge and an open-circuit voltage of the secondary cell, the relationship being calculated on the basis of a relationship between a state of charge and an open-circuit potential of the positive electrode, a relationship between a state of charge and an open-circuit potential of the negative electrode, a set deterioration state parameter of the positive electrode, and a set deterioration state parameter of the negative electrode;
   evaluating a deterioration state of the electrode on the basis of a comparison between the measured and the calculated relationship between the state of charge and the open circuit voltage of the secondary cell; and
   calculating (S11), for the other electrode of the positive electrode and the negative electrode, a relationship between a state of charge and an internal resistance of the secondary cell, the relationship being calculated on the basis of a relationship between the state of charge and an internal resistance of the positive electrode, a relationship between the state of charge and an internal resistance of the negative electrode, a set of deterioration state parameter of the positive electrode, and a set deterioration state parameter of the negative electrode;
   evaluating a deterioration state of the other electrode on the basis of a comparison between the measured and the calculated relationship between the state of charge and the internal resistance of the secondary cell.

2. The secondary cell state diagnosis method according to claim 1, wherein

an open circuit potential of the positive electrode or the negative electrode is constant except close to a fully charged state and close to a completely discharged state, and

for the electrode having a constant open circuit potential, the deterioration state of the electrode is evaluated on the basis of the relationship between the state of charge and the internal resistance of the positive electrode and the negative electrode and the relationship between the state of charge and the internal resistance of the secondary cell.

3. The secondary cell state diagnosis method according to claim 1 or 2, wherein the internal resistance is obtained on the basis of a closed circuit voltage when five seconds or more have elapsed since the start of energization from an open circuit state.

4. The secondary cell state diagnosis method according to any one of claims 1 to 3, further comprising:

measuring the relationship between a state of charge and an open-circuit voltage of a secondary cell using an active material of an unknown type;

determining the relationship between a state of charge and an open-circuit voltage of a secondary cell using an active material of a known type on the basis of the relationship between a state of charge and an open circuit potential of a positive electrode using an active material of a known type and the relationship between a state of charge and an open circuit potential of a negative electrode using an active material of a known type;

comparing the relationship between the state of charge and the open-circuit voltage of the secondary cell using the active material of the known type with the relationship between the state of charge and the open-circuit voltage of the secondary cell using an active material of the unknown type to specify the type of the active material of the unknown type; and

when the open circuit potential of one electrode of the positive electrode and the negative electrode is constant except close to a fully charged state and close to a completely discharged state, and the open circuit potential of the other electrode of the positive electrode and the negative electrode is not constant from close to the fully charged state to close to the completely discharged state,

evaluating the deterioration state for an electrode using an active material for which the open circuit potential is constant except close to a fully charged state and close to a completely discharged state, and an electrode using an active material for which the open circuit potential is not constant from close to the fully charged state to close to the completely discharged state.

5. The secondary cell state diagnosis method according to any one of claims 1 to 4, wherein the relationship between the state of charge and the open-circuit voltage of the secondary cell, and the relationship between the state of charge and the internal resistance of the secondary cell are repeatedly measured by charging for five seconds or more, discharging for five seconds or more, and pausing for five seconds or more.

6. The secondary cell state diagnosis method according to any one of claims 1 to 5, further comprising accumulating one or more of the evaluation results of the deterioration states of each of the electrodes and the evaluation results of the deterioration state of the secondary cell calculated on the basis of the evaluation results of the deterioration states of each of the electrodes,

wherein the accumulated evaluation results are used in a post-diagnosis change to an operating conditions range of the secondary cell, and

the operating conditions range of the secondary cell is one or more of an upper limit and a lower limit of the state of charge of the secondary cell, an upper limit and a lower limit of a current charging the secondary cell, and an upper limit and a lower limit of a discharge current from the secondary cell.

7. The secondary cell state diagnosis method according to claim 6, wherein, when the deterioration state of the positive electrode or the deterioration state of the negative electrode is equal to or greater than a threshold value, or when a rate of change in the deterioration state of the positive electrode or a rate of change in the deterioration state of the negative electrode with respect to a cumulative load amount of the secondary cell, which is calculated from a usage time of the secondary cell, an amount of energization of the secondary cell, or a combination of two or more of the usage time, the energization amount, a temperature, and a current, is equal to or greater than a threshold value, or when a remaining life of the secondary cell evaluated from the rate of change in the deterioration state, a current value of the deterioration state, and a threshold value of the deterioration state is equal to or less than a threshold value, the post-diagnosis operating conditions of the secondary cell are changed.

8. A state diagnosis device (100) that is configured to diagnose a deterioration state of a secondary cell, the device (100) comprising:

an arithmetic unit (10) that is configured to read data indicating a measured relationship between a state of charge and an open-circuit voltage of the secondary cell and data indicating a measured relationship between the state of charge and an internal resistance of the secondary cell, and configured to evaluate a deterioration state of an electrode; and

a storage unit (20) configured to store data indicating a relationship between a state of charge and an open-circuit voltage of a positive electrode, data indicating a relationship between a state of charge and an open-circuit voltage of a negative electrode, data indicating the relationship between the state of charge and an internal resistance of the positive electrode and data indicating a relationship between a state of charge and an internal resistance of the negative electrode,

wherein, for one electrode of the positive electrode and a negative electrode, the arithmetic unit is configured to:

calculate a relationship between a state of charge and an open-circuit voltage of the secondary cell, the relationship being calculated on the basis of the relationship between the state of charge and the open-circuit potential of the positive electrode, the relationship between the state of charge and the open-circuit potential of the negative electrode, a set deterioration state parameter of the positive electrode, and a set deterioration state parameter of the negative electrode,

evaluate a deterioration state of the electrode on the basis of a comparison between the measured and the calculated relationship between the state of charge and the open circuit voltage of the secondary cell; and

for the other electrode of the positive electrode and the negative electrode, the arithmetic unit is configured to:

calculate a relationship between a state and an internal resistance of the secondary cell, the relationship being calculated on the basis of the relationship between the state of charge and the internal resistance of the positive electrode, a relationship between a state of charge and an internal resistance of the negative electrode, a set deterioration state parameter of the positive electrode, and a set deterioration state parameter of the negative electrode;

evaluate a deterioration state of the other electrode on the basis of a comparison between the measured and the calculated relationship between the state of charge and the internal resistance of the secondary cell.

9. The secondary cell state diagnosis device (100) according to claim 8, wherein a relational expression or a data table indicating the relationship between the state of charge and the open-circuit voltage of the secondary cell, and a relational expression or a data table indicating the relationship between the state of charge and the internal resistance of the secondary cell are inputted to evaluate the deterioration state of the electrode.

**Patentansprüche**

1. Sekundärzellen-Zustandsdiagnoseverfahren zum Diagnostizieren eines Verschlechterungszustands einer Sekundärzelle, wobei das Verfahren Folgendes umfasst:

Empfangen (S1) von Messdaten, die eine Relation zwischen einem Ladungszustand und einer Leerlaufspannung der Sekundärzelle angeben;

Empfangen (S9) von Messdaten, die eine Relation zwischen einem Ladungszustand und einem Innenwiderstand der Sekundärzelle angeben;

Berechnen (S5) für eine Elektrode einer positiven Elektrode und einer negativen Elektrode einer Relation zwischen einem Ladungszustand und einer Leerlaufspannung der Sekundärzelle, wobei die Relation auf der Grundlage einer Relation zwischen einem Ladungszustand und einem Leerlaufpotential der positiven Elektrode, einer Relation zwischen einem Ladungszustand und einem Leerlaufpotential der negativen Elektrode, eines eingestellten Verschlechterungszustandsparameters der positiven Elektrode und eines eingestellten Verschlechterungszustandsparameters der negativen Elektrode berechnet wird;

Bewerten eines Verschlechterungszustands der Elektrode auf der Grundlage eines Vergleichs zwischen der gemessenen und der berechneten Relation zwischen dem Ladungszustand und der Leerlaufspannung der Sekundärzelle; und

Berechnen (S11) für die andere Elektrode der positiven Elektrode und der negativen Elektrode einer Relation zwischen einem Ladungszustand und einem Innenwiderstand der Sekundärzelle, wobei die Relation auf der Grundlage einer Relation zwischen dem Ladungszustand und einem Innenwiderstand der positiven Elektrode, einer Relation zwischen dem Ladungszustand und einem Innenwiderstand der negativen Elektrode, eines eingestellten Verschlechterungszustandsparameters der positiven Elektrode und eines eingestellten Verschlechterungszustandsparameters der negativen Elektrode berechnet wird;

Bewerten eines Verschlechterungszustands der anderen Elektrode auf der Grundlage eines Vergleichs zwischen der gemessenen und der berechneten Relation zwischen dem Ladungszustand und dem Innenwiderstand der Sekundärzelle.

2. Sekundärzellen-Zustandsdiagnoseverfahren nach Anspruch 1, wobei

ein Leerlaufpotential der positiven Elektrode oder der negativen Elektrode bis auf nahe an einem vollständig aufgeladenen Zustand und nahe an einem vollständig entladenen Zustand konstant ist, und

für die Elektrode mit einem konstanten Leerlaufpotential der Verschlechterungszustand der Elektrode auf der Grundlage der Relation zwischen dem Ladungszustand und dem Innenwiderstand der positiven Elektrode und der negativen Elektrode und der Relation zwischen dem Ladungszustand und dem Innenwiderstand der Sekundärzelle bewertet wird.

3. Sekundärzellen-Zustandsdiagnoseverfahren nach Anspruch 1 oder 2, wobei der Innenwiderstand auf der Grundlage einer Arbeitsspannung, wenn fünf Sekunden oder mehr seit dem Beginn der Energiezufuhr ausgehend von einem Leerlaufzustand vergangen sind, erhalten wird.

4. Sekundärzellen-Zustandsdiagnoseverfahren nach einem der Ansprüche 1 bis 3, das ferner Folgendes umfasst:

Messen der Relation zwischen einem Ladungszustand und einer Leerlaufspannung einer Sekundärzelle, die ein aktives Material einer unbekannten Art verwendet;

Bestimmen der Relation zwischen einem Ladungszustand und einer Leerlaufspannung einer Sekundärzelle, die ein aktives Material einer bekannten Art verwendet, auf der Grundlage der Relation zwischen einem Ladungszustand und einem Leerlaufpotential einer positiven Elektrode, die ein Material einer bekannten Art verwendet, und der Relation zwischen einem Ladungszustand und einem Leerlaufpotential einer negativen Elektrode, die ein aktives Material einer bekannten Art verwendet;

Vergleichen der Relation zwischen dem Ladungszustand und der Leerlaufspannung der Sekundärzelle, die das aktive Material der bekannten Art verwendet, mit der Relation zwischen dem Ladungszustand und der Leerlaufspannung der Sekundärzelle, die das aktive Material der unbekannten Art verwendet, um die Art des aktiven Materials der unbekannten Art zu spezifizieren; und

dann, wenn das Leerlaufpotential einer Elektrode der positiven Elektrode und der negativen Elektrode bis auf nahe an einem vollständig aufgeladenen Zustand und nahe an einem vollständig entladenen Zustand konstant ist, und das Leerlaufpotential der anderen Elektrode der positiven Elektrode und der negativen Elektrode von nahe am vollständig aufgeladenen Zustand bis nahe am vollständig entladenen Zustand nicht konstant ist,

Bewerten des Verschlechterungszustands für eine Elektrode, die ein aktives Material verwendet, für das das Leerlaufpotential bis auf nahe an einem vollständig aufgeladenen Zustand und nahe an einem vollständig entladenen Zustand konstant ist, und eine Elektrode, die ein aktives Material verwendet, für das das Leerlaufpotential von nahe am vollständig aufgeladenen Zustand bis nahe am vollständig entladenen Zustand nicht konstant ist.

5. Sekundärzellen-Zustandsdiagnoseverfahren nach einem der Ansprüche 1 bis 4, wobei die Relation zwischen dem Ladungszustand und der Leerlaufspannung der Sekundärzelle und die Relation zwischen dem Ladungszustand und dem Innenwiderstand der Sekundärzelle durch Aufladen für fünf Sekunden oder länger, Entladen für fünf Sekunden oder länger und Pausieren für fünf Sekunden oder länger wiederholt gemessen werden.

6. Sekundärzellen-Zustandsdiagnoseverfahren nach einem der Ansprüche 1 bis 5, das ferner das Sammeln eines oder mehrerer der Bewertungsergebnisse der Verschlechterungszustände jeder der Elektroden und der Bewertungsergebnisse des Verschlechterungszustands der Sekundärzelle, die auf der Grundlage der Bewertungsergebnisse der Verschlechterungszustände von jeder der Elektroden berechnet worden sind, umfasst,

wobei die gesammelten Bewertungsergebnisse bei einer Änderung nach der Diagnose an einem Arbeitsbedingungsbereich der Sekundärzelle verwendet werden, und

der Arbeitsbedingungsbereich der Sekundärzelle ein oberer Grenzwert und ein unterer Grenzwert des Ladungszustands der Sekundärzelle und/oder ein oberer Grenzwert und ein unterer Grenzwert eines Stroms, der die Sekundärzelle auflädt, und/oder ein oberer Grenzwert und ein unterer Grenzwert eines Entladestroms aus der Sekundärzelle ist.

7. Sekundärzellen-Zustandsdiagnoseverfahren nach Anspruch 6, wobei dann, wenn der Verschlechterungszustand der positiven Elektrode oder der Verschlechterungszustand der negativen Elektrode größer oder gleich einem Schwellenwert ist, oder dann, wenn eine Änderungsrate des Verschlechterungszustands der positiven Elektrode oder eine Änderungsrate des Verschlechterungszustands der negativen Elektrode in Bezug auf einen kumulativen Lastbetrag der Sekundärzelle, der aus einer Nutzungszeit der Sekundärzelle, einem Energiezufuhrbetrag der Sekundärzelle oder einer Kombination von zwei oder mehr der Nutzungszeit, des Energiezufuhrbetrags, einer Temperatur und eines Stroms berechnet wird, größer oder gleich einem Schwellenwert ist, oder dann, wenn eine Restlebensdauer der Sekundärzelle, die aus der Änderungsrate des Verschlechterungszustands, einem aktuellen Wert des Verschlechterungszustands und einem Schwellenwert des Verschlechterungszustands bewertet wird, kleiner oder gleich einem Schwellenwert ist, die Arbeitsbedingungen der Sekundärzelle nach der Diagnose geändert werden.

8. Zustandsdiagnosevorrichtung (100), die konfiguriert ist, einen Verschlechterungszustand einer Sekundärzelle zu diagnostizieren, wobei die Vorrichtung (100) Folgendes umfasst:

   eine Arithmetikeinheit (10), die konfiguriert ist, Daten, die eine gemessene Relation zwischen einem Ladungszustand und einer Leerlaufspannung der Sekundärzelle angeben, und Daten, die eine gemessene Relation zwischen dem Ladungszustand und einem Innenwiderstand der Sekundärzelle angeben, zu lesen, und konfiguriert ist, einen Verschlechterungszustand einer Elektrode zu bewerten; und
   eine Speichereinheit (20), die konfiguriert ist, Daten, die eine Relation zwischen einem Ladungszustand und einer Leerlaufspannung einer positiven Elektrode angeben, Daten die eine Relation zwischen einem Ladungszustand und einem Leerlaufspannung einer negativen Elektrode angeben, Daten, die eine Relation zwischen dem Ladungszustand und einem Innenwiderstand der positiven Elektrode angeben, und Daten, die eine Relation zwischen einem Ladungszustand und einem Innenwiderstand der negativen Elektrode angeben, zu speichern, wobei die Arithmetikeinheit für eine Elektrode der positiven Elektrode und einer negativen Elektrode konfiguriert ist zum:

   Berechnen einer Relation zwischen einem Ladungszustand und einer Leerlaufspannung der Sekundärzelle, wobei die Relation auf der Grundlage der Relation zwischen dem Ladungszustand und dem Leerlaufpotential der positiven Elektrode, der Relation zwischen dem Ladungszustand und dem Leerlaufpotential der negativen Elektrode, eines eingestellten Verschlechterungszustandsparameters der positiven Elektrode und eines eingestellten Verschlechterungszustandsparameters der negativen Elektrode berechnet wird, Bewerten eines Verschlechterungszustands der Elektrode auf der Grundlage eines Vergleichs zwischen der gemessenen und der berechneten Relation zwischen dem Ladungszustand und der Leerlaufspannung der Sekundärzelle; und
   wobei die Arithmetikeinheit für die andere Elektrode der positiven Elektrode und der negativen Elektrode konfiguriert ist zum:

   Berechnen einer Relation zwischen einem Zustand und einem Innenwiderstand der Sekundärzelle, wobei die Relation auf der Grundlage der Relation zwischen dem Ladungszustand und dem Innenwiderstand der positiven Elektrode, einer Relation zwischen einem Ladungszustand und einem Innenwiderstand der negativen Elektrode, eines eingestellten Verschlechterungszustandsparameters der positiven Elektrode und eines eingestellten Verschlechterungszustandsparameters der negativen Elektrode berechnet wird;
   Bewerten eines Verschlechterungszustands der anderen Elektrode auf der Grundlage eines Vergleichs zwischen der gemessenen und der berechneten Relation zwischen dem Ladungszustand und dem Innenwiderstand der Sekundärzelle.

9. Sekundärzellen-Zustandsdiagnosevorrichtung (100) nach Anspruch 8, wobei ein relationaler Ausdruck oder eine Datentabelle, die die Relation zwischen dem Ladungszustand und der Leerlaufspannung der Sekundärzelle angeben, und ein relationaler Ausdruck oder eine Datentabelle, die die Relation zwischen dem Ladungszustand und dem Innenwiderstand der Sekundärzelle angeben, eingegeben werden, um den Verschlechterungszustand der Elektrode zu bewerten.

**Revendications**

1.  Procédé de diagnostic d'état de cellule secondaire pour diagnostiquer un état de détérioration d'une cellule secondaire, le procédé comprenant les étapes consistant à :

    recevoir (S1) des données de mesurage indiquant une relation entre un état de charge et une tension en circuit ouvert de la cellule secondaire ;
    recevoir (S9) des données de mesurage indiquant une relation entre un état de charge et une résistance interne de la cellule secondaire ;
    calculer (S5), pour une électrode d'une électrode positive et d'une électrode négative, une relation entre un état de charge et une tension en circuit ouvert de la cellule secondaire, la relation étant calculée sur la base d'une relation entre un état de charge et un potentiel en circuit ouvert de l'électrode positive, d'une relation entre un état de charge et un potentiel en circuit ouvert de l'électrode négative, d'un paramètre d'état de détérioration défini de l'électrode positive, et d'un paramètre d'état de détérioration défini de l'électrode négative ;
    évaluer un état de détérioration de l'électrode sur la base d'une comparaison entre la relation mesurée et la relation calculée entre l'état de charge et la tension en circuit ouvert de la cellule secondaire ; et
    calculer (S11), pour l'autre électrode de l'électrode positive et de l'électrode négative, une relation entre un état de charge et une résistance interne de la cellule secondaire, la relation étant calculée sur la base d'une relation entre l'état de charge et une résistance interne de l'électrode positive, d'une relation entre l'état de charge et une résistance interne de l'électrode négative, d'un paramètre d'état de détérioration défini de l'électrode positive, et d'un paramètre d'état de détérioration défini de l'électrode négative ;
    évaluer un état de détérioration de l'autre électrode sur la base d'une comparaison entre la relation mesurée et la relation calculée entre l'état de charge et la résistance interne de la cellule secondaire.

2.  Procédé de diagnostic d'état de cellule secondaire selon la revendication 1, dans lequel

    un potentiel en circuit ouvert de l'électrode positive ou de l'électrode négative est constant, sauf proche d'un état entièrement chargé et proche d'un état complètement déchargé, et
    pour l'électrode ayant un potentiel en circuit ouvert constant, l'état de détérioration de l'électrode est évalué sur la base de la relation entre l'état de charge et la résistance interne de l'électrode positive et de l'électrode négative et de la relation entre l'état de charge et la résistance interne de la cellule secondaire.

3.  Procédé de diagnostic d'état de cellule secondaire selon la revendication 1 ou 2, dans lequel la résistance interne est obtenue sur la base d'une tension en circuit fermé quand cinq secondes ou plus se sont écoulées à partir du début de l'alimentation depuis un état en circuit ouvert.

4.  Procédé de diagnostic d'état de cellule secondaire selon l'une quelconque des revendications 1 à 3, comprenant en outre les étapes consistant à :

    mesurer la relation entre un état de charge et une tension en circuit ouvert d'une cellule secondaire à l'aide d'un matériau actif d'un type inconnu ;
    déterminer la relation entre un état de charge et une tension en circuit ouvert d'une cellule secondaire à l'aide d'un matériau actif d'un type connu sur la base de la relation entre un état de charge et un potentiel en circuit ouvert d'une électrode positive à l'aide d'un matériau actif d'un type connu et de la relation entre un état de charge et un potentiel en circuit ouvert d'une électrode négative à l'aide d'un matériau actif d'un type connu ;
    comparer la relation entre l'état de charge et la tension en circuit ouvert de la cellule secondaire à l'aide du matériau actif du type connu, à la relation entre l'état de charge et la tension en circuit ouvert de la cellule secondaire à l'aide d'un matériau actif du type inconnu pour spécifier le type du matériau actif du type inconnu ; et
    quand le potentiel en circuit ouvert d'une électrode de l'électrode positive et de l'électrode négative est constant, sauf proche d'un état entièrement chargé et proche d'un état complètement déchargé, et que le potentiel en circuit ouvert de l'autre électrode de l'électrode positive et de l'électrode négative n'est pas constant, depuis proche de l'état entièrement chargé jusqu'à proche de l'état complètement déchargé,
    évaluer l'état de détérioration pour une électrode à l'aide d'un matériau actif pour lequel le potentiel en circuit ouvert est constant, sauf proche d'un état entièrement chargé et proche d'un état complètement déchargé, et
    pour une électrode à l'aide d'un matériau actif pour lequel le potentiel en circuit ouvert n'est pas constant, depuis proche de l'état entièrement chargé jusqu'à proche de l'état complètement déchargé.

5.  Procédé de diagnostic d'état de cellule secondaire selon l'une quelconque des revendications 1 à 4, dans lequel la relation entre l'état de charge et la tension en circuit ouvert de la cellule secondaire, et la relation entre l'état de charge et la résistance interne de la cellule secondaire sont mesurées de manière répétée en chargeant pendant cinq secondes ou plus, en déchargeant pendant cinq secondes plus, et en faisant un arrêt pendant cinq secondes ou plus.

6. Procédé de diagnostic d'état de cellule secondaire selon l'une quelconque des revendications 1 à 5, comprenant en outre l'étape consistant à accumuler un ou plusieurs des résultats d'évaluation des états de détérioration de chacune des électrodes et des résultats d'évaluation de l'état de détérioration de la cellule secondaire calculés sur la base des résultats d'évaluation des états de détérioration de chacune des électrodes, dans lequel les résultats d'évaluation accumulés sont utilisés dans un changement post-diagnostic pour une plage de conditions de fonctionnement de la cellule secondaire, et

la plage de conditions de fonctionnement de la cellule secondaire est l'une ou plusieurs d'une limite supérieure et d'une limite inférieure de l'état de charge de la cellule secondaire, d'une limite supérieure et d'une limite inférieure d'un courant de charge de la cellule secondaire, et d'une limite supérieure et d'une limite inférieure d'un courant de décharge depuis la cellule secondaire.

7. Procédé de diagnostic d'état de cellule secondaire selon la revendication 6, dans lequel, quand l'état de détérioration de l'électrode positive ou l'état de détérioration de l'électrode négative est égal ou supérieur à une valeur seuil, ou quand un taux de changement dans l'état de détérioration de l'électrode positive ou un taux de changement dans l'état de détérioration de l'électrode négative par rapport à une quantité de charge cumulée de la cellule secondaire, qui est calculée à partir d'une durée d'utilisation de la cellule secondaire, d'une quantité d'alimentation de la cellule secondaire, ou d'une combinaison de deux ou plusieurs de la durée d'utilisation, de la quantité d'alimentation, d'une température et d'un courant, est égal ou supérieur à une valeur seuil, ou quand une durée de vie résiduelle de la cellule secondaire évaluée à partir du taux de changement dans l'état de détérioration, d'une valeur actuelle de l'état de détérioration, et d'une valeur seuil de l'état de détérioration, est égal ou inférieur à une valeur seuil, les conditions de fonctionnement post-diagnostic de la cellule secondaire sont changées.

8. Dispositif de diagnostic d'état (100) qui est configuré pour diagnostiquer un état de détérioration d'une cellule secondaire, le dispositif (100) comprenant :

une unité arithmétique (10) qui est configurée pour lire des données indiquant une relation mesurée entre un état de charge et une tension en circuit ouvert de la cellule secondaire et des données indiquant une relation mesurée entre l'état de charge et une résistance interne de la cellule secondaire, et qui est configurée pour évaluer un état de détérioration d'une électrode ; et

une unité de stockage (20) configurée pour stocker des données indiquant une relation entre un état de charge et une tension en circuit ouvert d'une électrode positive, des données indiquant une relation entre un état de charge et une tension en circuit ouvert d'une électrode négative, des données indiquant la relation entre l'état de charge et une résistance interne de l'électrode positive, et des données indiquant une relation entre un état de charge et une résistance interne de l'électrode négative,

dans lequel, pour une électrode de l'électrode positive et d'une électrode négative, l'unité arithmétique est configurée pour :

calculer une relation entre un état de charge et une tension en circuit ouvert de la cellule secondaire, la relation étant calculée sur la base de la relation entre l'état de charge et le potentiel en circuit ouvert de l'électrode positive, de la relation entre l'état de charge et le potentiel en circuit ouvert de l'électrode négative, d'un paramètre d'état de détérioration défini de l'électrode positive, et d'un paramètre d'état de détérioration défini de l'électrode négative,

évaluer un état de détérioration de l'électrode sur la base d'une comparaison entre la relation mesurée et la relation calculée entre l'état de charge et la tension en circuit ouvert de la cellule secondaire ; et

pour l'autre électrode de l'électrode positive et de l'électrode négative, l'unité arithmétique est configurée pour :

calculer une relation entre un état et une résistance interne de la cellule secondaire, la relation étant calculée sur la base de la relation entre l'état de charge et la résistance interne de l'électrode positive, d'une relation entre un état de charge et une résistance interne de l'électrode négative, d'un paramètre d'état de détérioration défini de l'électrode positive, et d'un paramètre d'état de détérioration défini de l'électrode négative ;

évaluer un état de détérioration de l'autre électrode sur la base d'une comparaison entre la relation mesurée et la relation calculée entre l'état de charge et la résistance interne de la cellule secondaire.

9. Dispositif de diagnostic d'état de cellule secondaire (100) selon la revendication 8, dans lequel une expression de relation ou une table de données indiquant la relation entre l'état de charge et la tension en circuit ouvert de la cellule secondaire, et une expression de relation ou une table de données indiquant la relation entre l'état de charge et la résistance interne de la cellule secondaire sont entrées pour évaluer l'état de détérioration de l'électrode.

# FIG. 1

## FIG. 2

START

READ MEASUREMENT DATA OF OPEN-CIRCUIT VOLTAGE OF BATTERY — S1

READ DATA OF OPEN-CIRCUIT POTENTIALS OF POSITIVE ELECTRODE AND NEGATIVE ELECTRODE — S2

PROVISIONALLY SET POSITIVE ELECTRODE DETERIORATION STATE PARAMETERS — S3

SET NEGATIVE ELECTRODE DETERIORATION STATE PARAMETERS — S4

GENERATE CALCULATION DATA OF OPEN-CIRCUIT VOLTAGE OF BATTERY — S5

COMPARE CALCULATION DATA WITH MEASUREMENT DATA — S6

DO CALCULATION DATA AND MEASUREMENT DATA MATCH? — S7
No
Yes

READ MEASUREMENT DATA OF BATTERY INTERNAL RESISTANCE — S8

READ DATA OF POSITIVE ELECTRODE AND NEGATIVE ELECTRODE INTERNAL RESISTANCE — S9

SET POSITIVE ELECTRODE DETERIORATION STATE PARAMETERS — S10

GENERATE CALCULATION DATA OF BATTERY INTERNAL RESISTANCE — S11

COMPARE CALCULATION DATA WITH MEASUREMENT DATA — S12

DO CALCULATION DATA AND MEASUREMENT DATA MATCH? — S13
No
Yes

END

## FIG. 3

## FIG. 4

*FIG. 5*

## FIG. 6

## FIG. 7

*FIG. 8*

Cell_exp.
Cell_calc.
pos_calc.
neg_calc.

Internal Resistance (mΩ)

2    1.5    1    0.5    0

−0.1    −0.05    0    0.05    0.1

Capacity Qc(Ah)

FIG. 9

## FIG. 10

EP 4 439 102 B1

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2009080093 A
- US 2020217901 A1
- KR 101610906 B1
- US 2021167607 A1
- US 2021270907 A1

- JP 2015230817 A
- JP 2014160592 A
- JP 2014149280 A
- JP 6918433 B
- CN 105242212 A

**Non-patent literature cited in the description**

- **HONKURA, KOHEI** ; **ODA, MASANARI** ; **ITO, SHOTA** ; **SUGIMASA, MASATOSHI** ; **KAWAJI, JUN**. Prediction technique of capacity fade and impedance rise of LIB based on the discharge curve analysis. *60th Battery Symposium in Japan*, 13 November 2019, vol. 60, 550